# EUROPEAN PATENT SPECIFICATION

(11) **EP 3 636 726 B1**
(45) Date of publication and mention of the grant of the patent: **14.07.2021**
(21) Application number: 19209591.7
(22) Date of filing: 13.05.2016
(51) Int. Cl.: C09K 11/06, H01L 51/54, H01L 27/32

(54) **MULTI-COMPONENT HOST MATERIAL AND ORGANIC ELECTROLUMINESCENT DEVICE COMPRISING THE SAME**
MEHRKOMPONENTIGES HOST-MATERIAL UND ORGANISCHE ELEKTROLUMINESZENTE VORRICHTUNG DAMIT
MATÉRIAU HÔTE MULTICOMPOSANT ET DISPOSITIF ÉLECTROLUMINESCENT ORGANIQUE COMPRENANT CE MATÉRIAU

(30) Priority: 26.06.2015 KR 20150091223; 07.01.2016 KR 20160002171; 21.04.2016 KR 20160048912
(43) Date of publication of application: 15.04.2020
(62) Divisional of application: 16814586.0
(73) Proprietor: Rohm And Haas Electronic Materials Korea Ltd., Chungcheongnam-do 331-980 (Baekseok-dong) (KR)
(72) Inventor: PARK, Kyoung-Jin, 18449 Gyenggi-Do (KR); KIM, Bitnari, 18449 Gyenggi-Do (KR); DOH, Yoo-Jin, 18449 Gyenggi-Do (KR); KANG, Hyun-Ju, 18449 Gyenggi-Do (KR); LIM, Young-Mook, 18449 Gyenggi-Do (KR); LEE, Su-Hyun, 18449 Gyenggi-Do (KR); KIM, Chi-Sik, 18449 Gyenggi-Do (KR)
(74) Representative: Houghton, Mark Phillip

(56) References cited:
- WO-A1-2015/156587
- US-A1- 2013 234 119

## Description

### Technical Field

The present invention relates to a multi-component host material and an organic electroluminescent device comprising the same.

### Background Art

An electroluminescent device (EL device) is a self-light-emitting device which has advantages in that it provides a wider viewing angle, a greater contrast ratio, and a faster response time. The first organic EL device was developed by Eastman Kodak, by using small aromatic diamine molecules, and aluminum complexes as materials for forming a light-emitting layer [Appl. Phys. Lett. 51, 913, 1987].

An organic electroluminescent device is a device changing electrical energy to light by applying electricity to an organic electroluminescent material, and generally has a structure comprising an anode, a cathode, and an organic layer between the anode and the cathode. The organic layer of an organic EL device may be comprised of a hole injection layer, a hole transport layer, an electron blocking layer, a light-emitting layer (which comprises host and dopant materials), an electron buffer layer, a hole blocking layer, an electron transport layer, an electron injection layer, etc., and the materials used for the organic layer are categorized by their functions in hole injection material, hole transport material, electron blocking material, light-emitting material, electron buffer material, hole blocking material, electron transport material, electron injection material, etc. In the organic EL device, due to an application of a voltage, holes are injected from the anode to the light-emitting layer, electrons are injected from the cathode to the light-emitting layer, and excitons of high energies are formed by a recombination of the holes and the electrons. By this energy, luminescent organic compounds reach an excited state, and light emission occurs by emitting light from energy due to the excited state of the luminescent organic compounds returning to a ground state.

The most important factor determining luminous efficiency in an organic EL device is light-emitting materials. A light-emitting material must have high quantum efficiency, high electron and hole mobility, and the formed light-emitting material layer must be uniform and stable. Light-emitting materials are categorized into blue, green, and red light-emitting materials dependent on the color of the light emission, and additionally yellow or orange light-emitting materials. In addition, light-emitting materials can also be categorized into host and dopant materials according to their functions. Recently, the development of an organic EL device providing high efficiency and long lifespan is an urgent issue. In particular, considering EL characteristic requirements for a middle or large-sized panel of OLED, materials showing better characteristics than conventional ones must be urgently developed. The host material, which acts as a solvent in a solid state and transfers energy, needs to have high purity and a molecular weight appropriate for vacuum deposition. Furthermore, the host material needs to have high glass transition temperature and high thermal degradation temperature to achieve thermal stability, high electro-chemical stability to achieve long lifespan, ease of forming an amorphous thin film, good adhesion to materials of adjacent layers, and non-migration to other layers.

A light-emitting material can be used as a combination of a host and a dopant to improve color purity, luminous efficiency, and stability. Generally, an EL device having excellent characteristics has a structure comprising a light-emitting layer formed by doping a dopant to a host. Since host materials greatly influence the efficiency and lifespan of the EL device when using a dopant/host material system as a light-emitting material, their selection is important.

Korean Patent Application Laying-Open No. 10-2015-0003658 discloses an organic optoelectric device and display device using a multi-component host, wherein a compound of a structure in which heteroaryl groups are bonded to each nitrogen atom of an indole-carbazole residue, where the 6-membered heteroaryl ring directly connected to a nitrogen atom has substituents of a 6-membered ring connected to each of the meta positions is used as a first host compound, and a carbazole-carbazole derivative is used as a second host compound of the host combination. In addition, Korean Patent No. 10-1502316 is a patent of the applicant of the present invention, which is related to a multi-component host and an organic electroluminescent device comprising the same using a carbazole-aryl-carbazole derivative as a first host compound and a compound having a structure wherein a nitrogen-containing heteroaryl group is bonded to a nitrogen atom of a carbazole (via an aryl group).

WO2015/156587 discloses an organic electroluminescent device comprising at least one orgnic light-emitting layer between an anode and a cathode, wherein the light-emitting layer comprises a host and a phosphorescent dopant; the host consists of multi-component host compounds, at least a first host compound of the multi-component host is a specific bicarbazole derivative containing an aryl group, and a second host compound is a specific carbazole derivative including a nitrogen-containing heteroaryl group.

US 2013/234119 A1 discloses an organic electroluminescence device employing a specific biscarbazole derivative having a cyano group as a first host and a compound having both a carbazole structure and a nitrogen-containing aromatic heteroring as a second host.

The present inventors found that by using a first host compound having a structure of a nitrogen-containing heterocyclic linker bonded to a nitrogen atom of a carbazole of an indole-carbazole, indene-carbazole, benzofuran-carbazole, or benzothiophene-carbazole residue and a second host compound of a carbazole-aryl-carbazole or carbazole-carbazole derivative, the organic electroluminescent device comprising the host combination can provide an effect of improved lifespan compared to a device using conventional host materials.

### Disclosure of the Invention

### Problems to be Solved

The objective of the present invention is to provide an organic electroluminescent device having excellent efficiency and long lifespan.

### Solution to Problems

The invention is set out in accordance with the appended claims. The present inventors found that the objective above can be achieved by an organic electroluminescent device comprising at least one light-emitting layer between an anode and a cathode, wherein the light-emitting layer comprises a host and a phosphorescent dopant; the host comprises plural host compounds; at least a first host compound of the plural host compounds is represented by the following formula 1; and a second host compound is represented by the following formula 2: 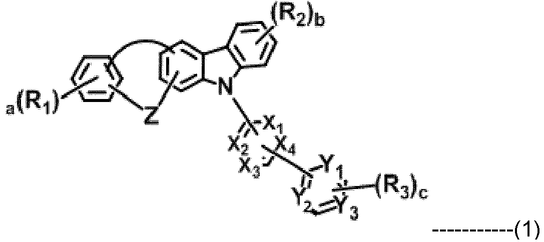 wherein
Z represents NR₄;
X₁ to X₄ each independently represent N or C(R₇), one or more of X₁ to X₄ is N;
Y₁ to Y₃ each independently represent N or C(R₈), two or more of Y₁ to Y₃ are N; R₁ to R₄, R₇ and R₈ each independently represent hydrogen, deuterium, a halogen, a cyano, a substituted or unsubstituted (C1-C30)alkyl, a substituted or unsubstituted (C6-C30)aryl, a substituted or unsubstituted 3- to 30-membered heteroaryl, a substituted or unsubstituted (C3-C30)cycloalkyl, a substituted or unsubstituted (C1-C30)alkoxy, a substituted or unsubstituted tri(C1-C30)alkylsilyl, a substituted or unsubstituted di(C1-C30)alkyl(C6-C30)arylsilyl, a substituted or unsubstituted (C1-C30)alkyldi(C6-C30)arylsilyl, a substituted or unsubstituted tri(C6-C30)arylsilyl, a substituted or unsubstituted mono- or di- (C1-C30)alkylamino, a substituted or unsubstituted mono- or di- (C6-C30)arylamino, or a substituted or unsubstituted (C1-C30)alkyl(C6-C30)arylamino; or may be linked to an adjacent substituent to form a substituted or unsubstituted mono- or polycyclic, (C3-C30) alicyclic or aromatic ring, whose carbon atom(s) may be replaced with at least one heteroatom selected from nitrogen, oxygen, and sulfur;
a and b each independently represent an integer of 1 to 4;
c represents 1 or 2;
where a, b, or c is an integer of 2 or more, each of R₁, each of R₂, or each of R₃ may be the same or different; and
the heteroaryl contains at least one heteroatom selected from B, N, O, S, Si, and P. 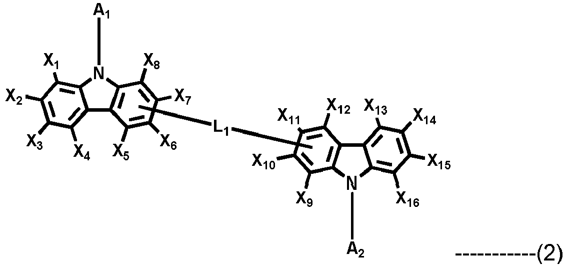 wherein
A₁ and A₂ each independently represent a (C6-C30)aryl unsubstituted or substituted with deuterium, a (C1-C30)alkyl, a (C6-C30)aryl or a tri(C6-C30)arylsilyl;
L₁ represents a substituted or unsubstituted (C6-C30)arylene; and
X₁ to X₁₆ each independently represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, or a substituted or unsubstituted mono- or di- (C6-C30)arylamino; or adjacent substituents may be linked to each other to form a substituted or unsubstituted mono- or polycyclic, (C3-C30) alicyclic or aromatic ring, whose carbon atom(s) may be replaced with at least one heteroatom selected from nitrogen, oxygen, and sulfur.

### Effects of the Invention

According to the present invention, an organic electroluminescent device having high efficiency and long lifespan is provided, and a display device or a lighting device using the organic electroluminescent device can be manufactured.

### Embodiments of the Invention

Hereinafter, the present invention will be described in detail. However, the following description is intended to explain the invention, and is not meant in any way to restrict the scope of the invention.

The compound of formula 1 can be represented by one of the following formulas 3 and 4: 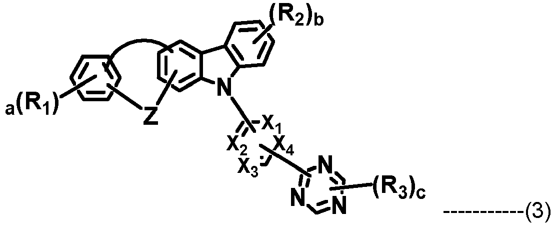 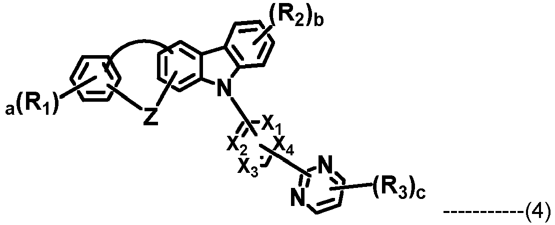 wherein
R₁ to R₃, X₁ to X₄, Z, and a to c are as defined in formula 1.

Specifically, the compound of formula 1 can be represented by one of the following formulas 5 to 7: 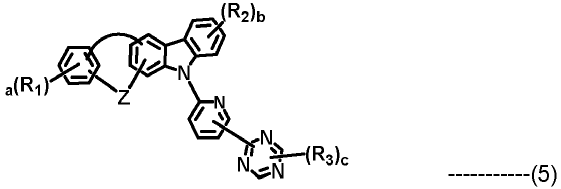 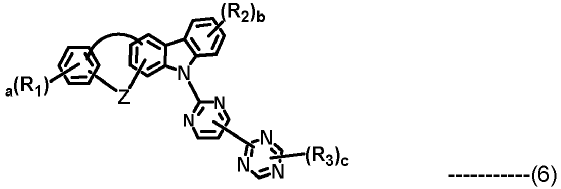 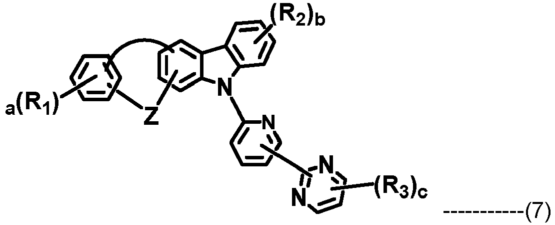 wherein
R₁ to R₃, Z, and a to c are as defined in formula 1.

In addition, the structure of 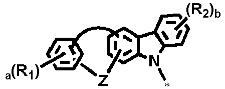 in formula 1 can be represented by one of the following formulas 8 to 13: 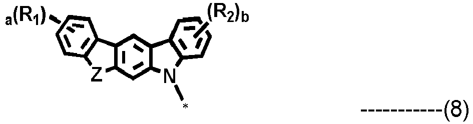 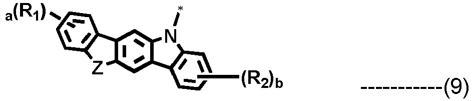 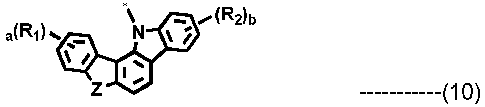 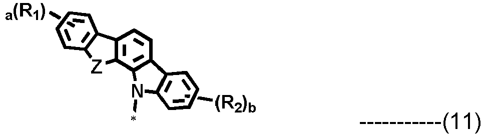 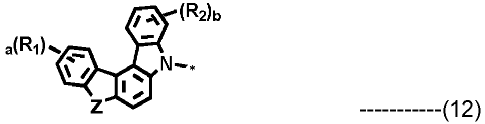 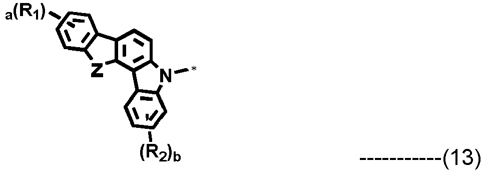 wherein
R₁, R₂, Z, a, and b are as defined in formula 1.

In another embodiment, formula 2 of the present invention can be represented by one of the following formulas 14 to 17: 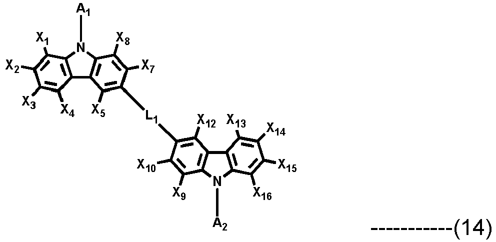 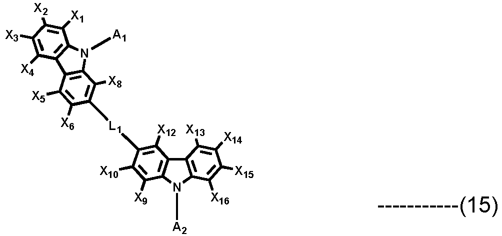 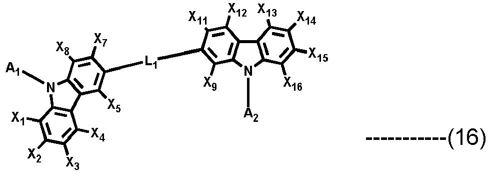 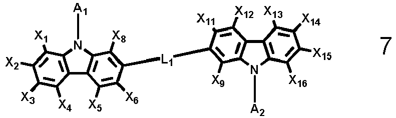 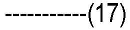 wherein
A₁, A₂, L₁, and X₁ to X₁₆ are as defined in formula 2.

In formula 1 above, R₁ to R₄, R₇ and R₈, preferably each independently, represent hydrogen, deuterium, a substituted or unsubstituted (C1-C20)alkyl, a substituted or unsubstituted (C6-C20)aryl, a substituted or unsubstituted 3- to 20-membered heteroaryl, a substituted or unsubstituted (C3-C20)cycloalkyl, a substituted or unsubstituted (C1-C20)alkoxy, a substituted or unsubstituted tri(C1-C20)alkylsilyl, a substituted or unsubstituted di(C1-C20)alkyl(C6-C20)arylsilyl, a substituted or unsubstituted (C1-C20)alkyldi(C6-C20)arylsilyl, a substituted or unsubstituted tri(C6-C20)arylsilyl, a substituted or unsubstituted mono- or di- (C1-C20)alkylamino, a substituted or unsubstituted mono- or di- (C6-C20)arylamino, or a substituted or unsubstituted (C1-C20)alkyl(C6-C20)arylamino; or may be linked to an adjacent substituent to form a substituted or unsubstituted mono- or polycyclic, (C3-C20) alicyclic or aromatic ring, whose carbon atom(s) may be replaced with at least one heteroatom selected from nitrogen, oxygen, and sulfur; and more preferably each independently represent hydrogen, deuterium, a substituted or unsubstituted (C1-C10)alkyl, a substituted or unsubstituted (C6-C15)aryl, a substituted or unsubstituted 3- to 15-membered heteroaryl, a substituted or unsubstituted (C3-C15)cycloalkyl, a substituted or unsubstituted (C1-C10)alkoxy, a substituted or unsubstituted tri(C1-C10)alkylsilyl, a substituted or unsubstituted di(C1-C10)alkyl(C6-C15)arylsilyl, a substituted or unsubstituted (C1-C10)alkyldi(C6-C15)arylsilyl, a substituted or unsubstituted tri(C6-C15)arylsilyl, a substituted or unsubstituted mono- or di- (C1-C10)alkylamino, a substituted or unsubstituted mono- or di- (C6-C15)arylamino, or a substituted or unsubstituted (C1-C10)alkyl(C6-C15)arylamino; or may be linked to an adjacent substituent to form a substituted or unsubstituted mono- or polycyclic, (C3-C15) alicyclic or aromatic ring, whose carbon atom(s) may be replaced with at least one heteroatom selected from nitrogen, oxygen, and sulfur.

In formula 2 above, A₁ and A₂ preferably each independently are selected from the group consisting of phenyl, biphenyl, terphenyl, naphthyl, fluorenyl, benzofluorenyl, phenanthrenyl, anthracenyl, indenyl, triphenylenyl, pyrenyl, tetracenyl, perylenyl, chrysenyl, and fluoranthenyl.

In addition, in formula 2 above, L₁ preferably represents one of the following formulas 18 to 30: 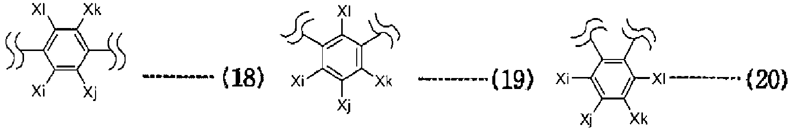 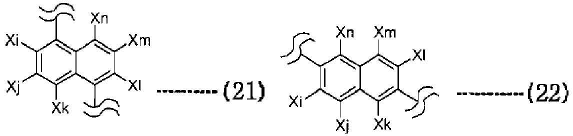 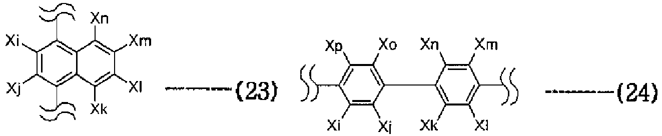 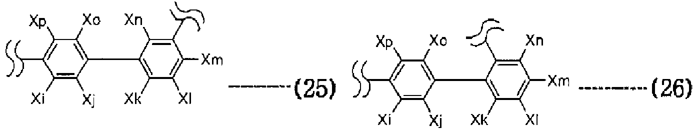 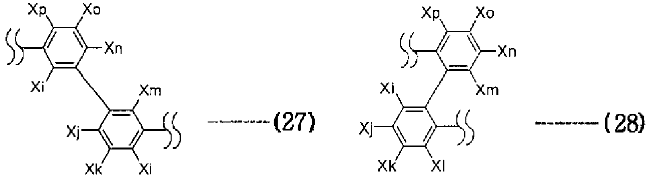 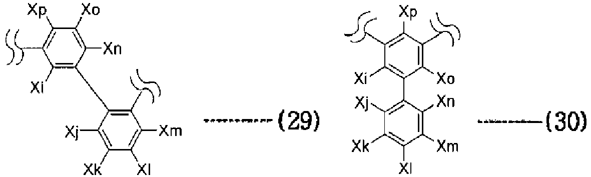 wherein
Xi to Xp each independently represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, or a substituted or unsubstituted mono- or di- (C6-C30)arylamino; or adjacent substituents may be linked to each other to form a substituted or unsubstituted, mono- or polycyclic, (C3-C30) alicyclic or aromatic ring, whose carbon atom(s) may be replaced with at least one heteroatom selected from nitrogen, oxygen, and sulfur.

Preferably, in formulas 18 to 30, Xi to Xp preferably each independently represent hydrogen, deuterium, a substituted or unsubstituted (C1-C20)alkyl, a substituted or unsubstituted (C2-C20)alkenyl, a substituted or unsubstituted (C2-C20)alkynyl, a substituted or unsubstituted (C3-C20)cycloalkyl, a substituted or unsubstituted (C6-C20)aryl, a substituted or unsubstituted 3- to 20-membered heteroaryl, a substituted or unsubstituted tri(C1-C20)alkylsilyl, a substituted or unsubstituted tri(C6-C20)arylsilyl, a substituted or unsubstituted di(C1-C20)alkyl(C6-C20)arylsilyl, or a substituted or unsubstituted mono- or di- (C6-C20)arylamino; or adjacent substituents may be linked to each other to form a substituted or unsubstituted, mono- or polycyclic, (C3-C20) alicyclic or aromatic ring, whose carbon atom(s) may be replaced with at least one heteroatom selected from nitrogen, oxygen, and sulfur.

Herein, "(C1-C30)alkyl" is meant to be a linear or branched alkyl having 1 to 30 carbon atoms constituting the chain, in which the number of carbon atoms is preferably 1 to 20, more preferably 1 to 10, and includes methyl, ethyl, n-propyl, isopropyl, n-butyl, isobutyl, tert-butyl, etc.; "(C2-C30)alkenyl" is meant to be a linear or branched alkenyl having 2 to 30 carbon atoms constituting the chain, in which the number of carbon atoms is preferably 2 to 20, more preferably 2 to 10, and includes vinyl, 1-propenyl, 2-propenyl, 1-butenyl, 2-butenyl, 3-butenyl, 2-methylbut-2-enyl, etc.; "(C2-C30)alkynyl" is meant to be a linear or branched alkynyl having 2 to 30 carbon atoms constituting the chain, in which the number of carbon atoms is preferably 2 to 20, more preferably 2 to 10, and includes ethynyl, 1-propynyl, 2-propynyl, 1-butynyl, 2-butynyl, 3-butynyl, 1-methylpent-2-ynyl, etc.; "(C1-C30)alkoxy" is meant to be a linear or branched alkyl having 1 to 30 carbon atoms constituting the chain, in which the number of carbon atoms is preferably 1 to 20, more preferably 1 to 10, and includes methoxy, ethoxy, propoxy, isopropoxy, 1-ethylpropoxy, etc.; "(C3-C30)cycloalkyl" is a mono- or polycyclic hydrocarbon having 3 to 30 ring backbone carbon atoms, in which the number of carbon atoms is preferably 3 to 20, more preferably 3 to 7, and includes cyclopropyl, cyclobutyl, cyclopentyl, cyclohexyl, etc.; "3- to 7- membered heterocycloalkyl" is a cycloalkyl having 3 to 7 ring backbone atoms, preferably 5 to 7, including at least one heteroatom selected from B, N, O, S, Si, and P, preferably O, S, and N, and includes tetrahydrofuran, pyrrolidine, thiolan, tetrahydropyran, etc.; "(C6-C30)aryl(ene)" is a monocyclic or fused ring derived from an aromatic hydrocarbon having 6 to 30 ring backbone carbon atoms, in which the number of carbon atoms is preferably 6 to 20, more preferably 6 to 15, and includes phenyl, biphenyl, terphenyl, naphthyl, fluorenyl, phenanthrenyl, anthracenyl, indenyl, triphenylenyl, pyrenyl, tetracenyl, perylenyl, chrysenyl, naphthacenyl, fluoranthenyl, etc.; "3- to 30-membered heteroaryl(ene)" is an aryl having 3 to 30 ring backbone atoms, preferably 3 to 20 ring backbone atoms, and more preferably 3 to 15 ring backbone atoms, including at least one, preferably 1 to 4 heteroatoms selected from the group consisting of B, N, O, S, Si, and P; is a monocyclic ring, or a fused ring condensed with at least one benzene ring; may be partially saturated; may be one formed by linking at least one heteroaryl or aryl group to a heteroaryl group via a single bond(s); and includes a monocyclic ring-type heteroaryl including furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl, etc., and a fused ring-type heteroaryl including benzofuranyl, benzothiophenyl, isobenzofuranyl, dibenzofuranyl, dibenzothiophenyl, benzimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenoxazinyl, phenanthridinyl, benzodioxolyl, etc. Further, "halogen" includes F, CI, Br, and I.

Herein, "substituted" in the expression "substituted or unsubstituted" means that a hydrogen atom in a certain functional group is replaced with another atom or group, i.e. a substituent. In formulas 1 and 2, the substituents of the substituted alkyl, the substituted alkenyl, the substituted alkynyl, the substituted alkoxy, the substituted cycloalkyl, the substituted trialkylsilyl, the substituted dialkylarylsilyl, the substituted alkyldiarylsilyl, the substituted triarylsilyl, the substituted mono- or di- alkylamino, the substituted mono- or diarylamino, the substituted alkylarylamino, the substituted aryl(ene), the substituted heteroaryl, and the substituted mono- or polycyclic, (C3-C30) alicyclic or aromatic ring in R₁ to R₄, R₇ and R₈, L₁, and X₁ to X₁₆ each independently are at least one selected from the group consisting of deuterium, a halogen, a cyano, a carboxyl, a nitro, a hydroxyl, a (C1-C30)alkyl, a halo(C1-C30)alkyl, a (C2-C30) alkenyl, a (C2-C30) alkynyl, a (C1-C30)alkoxy, a (C1-C30)alkylthio, a (C3-C30)cycloalkyl, a (C3-C30)cycloalkenyl, a 3- to 7-membered heterocycloalkyl, a (C6-C30)aryloxy, a (C6-C30)arylthio, a 3- to 30-membered heteroaryl unsubstituted or substituted with a (C6-C30)aryl, a (C6-C30)aryl unsubstituted or substituted with a 3- to 30-membered heteroaryl, a tri(C1-C30)alkylsilyl, a tri(C6-C30)arylsilyl, a di(C1-C30)alkyl(C6-C30)arylsilyl, a (C1-C30)alkyldi(C6-C30)arylsilyl, an amino, a mono- or di-(C1-C30)alkylamino, a mono- or di- (C6-C30)arylamino, a (C1-C30)alkyl(C6-C30)arylamino, a (C1-C30)alkylcarbonyl, a (C1-C30)alkoxycarbonyl, a (C6-C30)arylcarbonyl, a di(C6-C30)arylboronyl, a di(C1-C30)alkylboronyl, a (C1-C30)alkyl(C6-C30)arylboronyl, a (C6-C30)aryl(C1-C30)alkyl, and a (C1-C30)alkyl(C6-C30)aryl.

The first host compound represented by formula 1 includes the following compounds, but is not limited thereto:

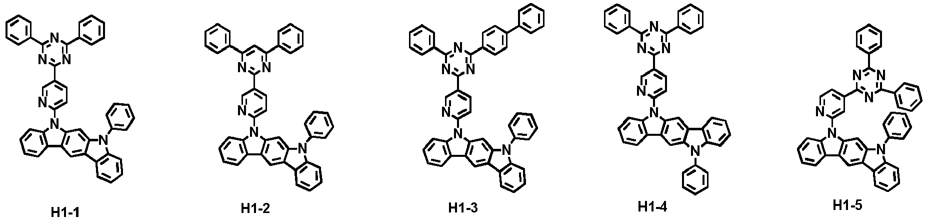

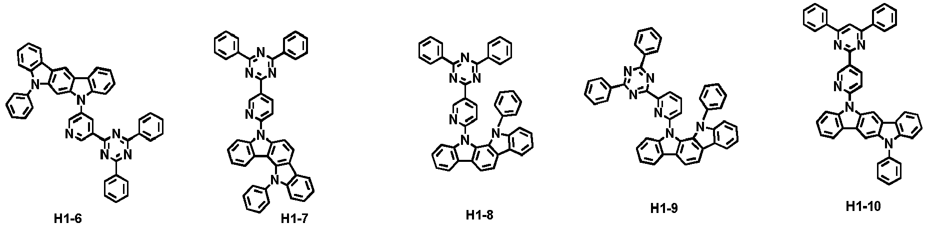

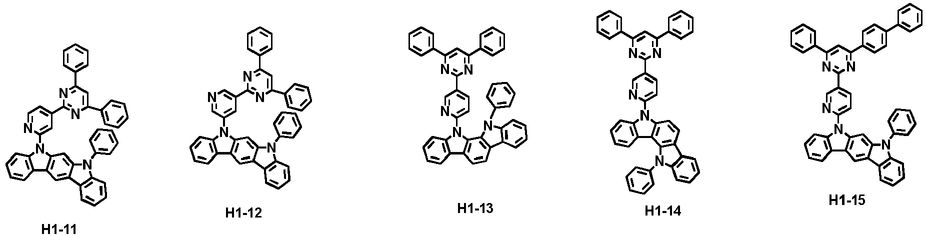

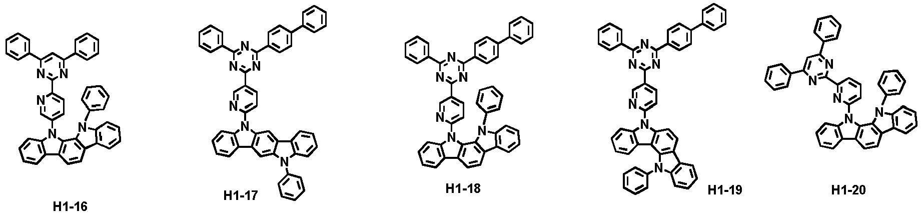

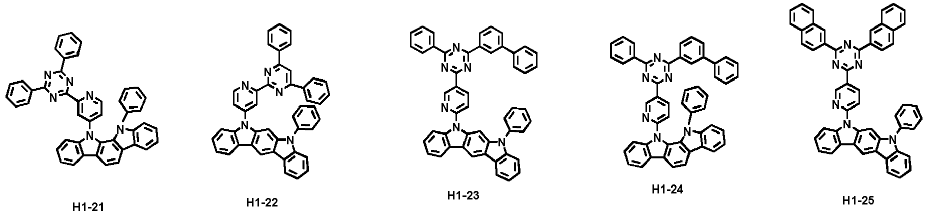

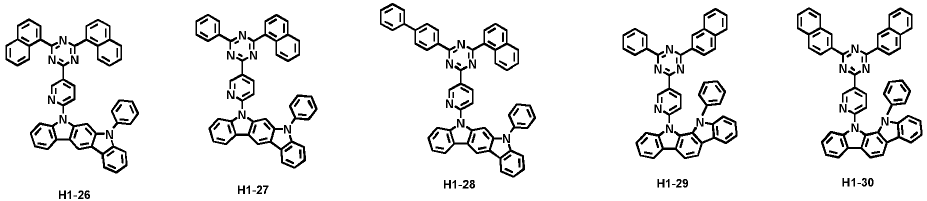

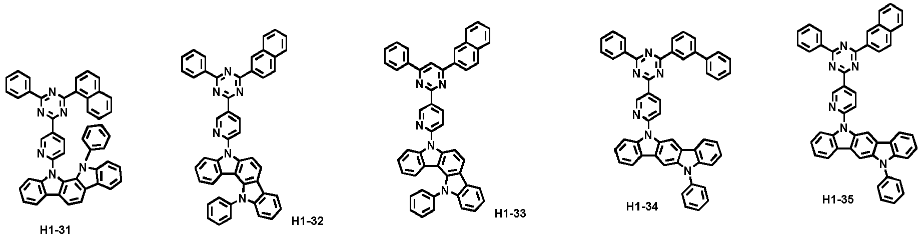

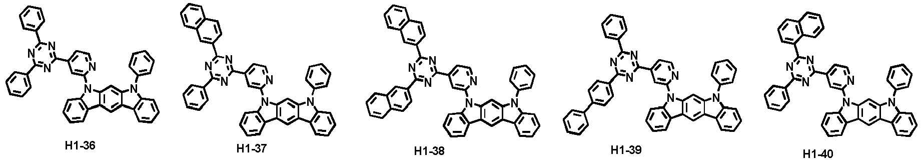

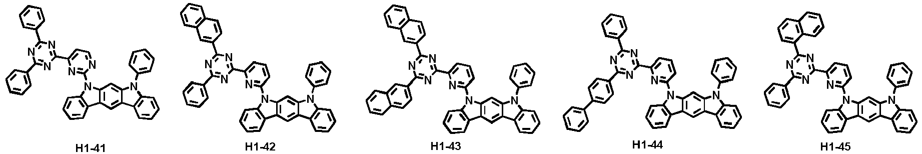

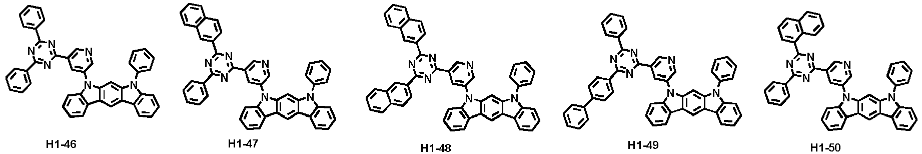

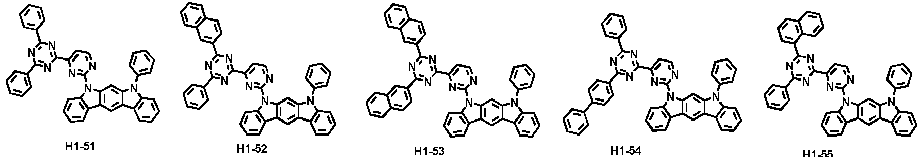

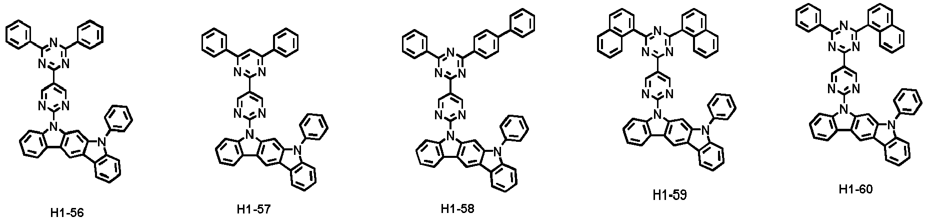

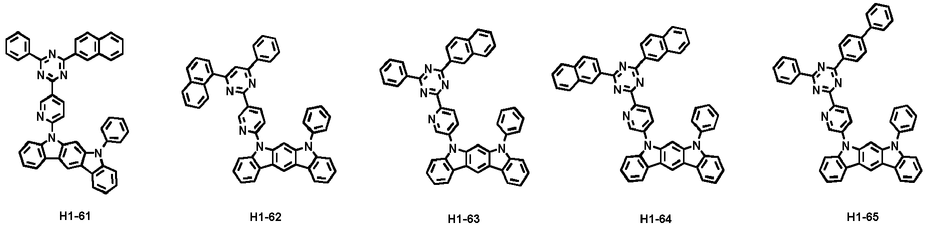

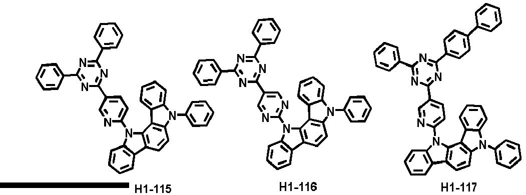

The second host compound represented by formula 2 includes the following compounds, but is not limited thereto:

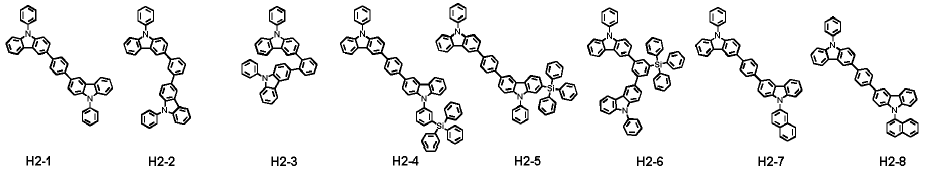

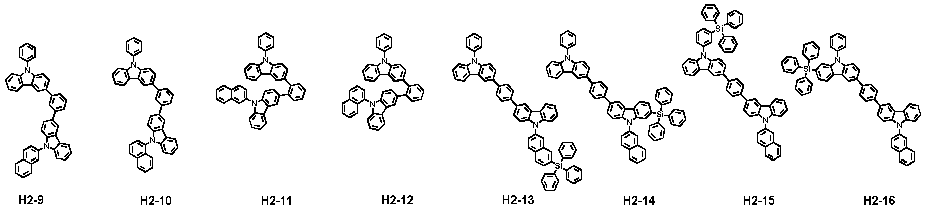

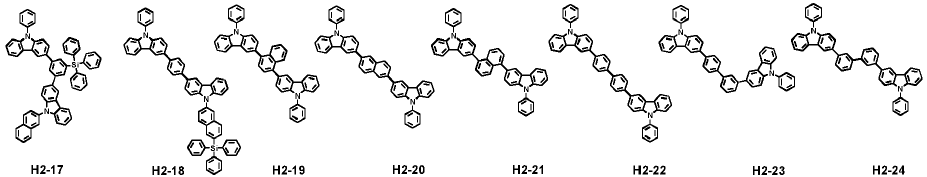

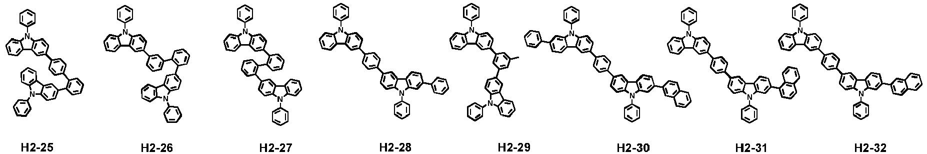

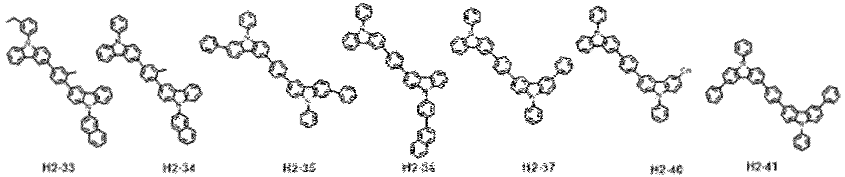

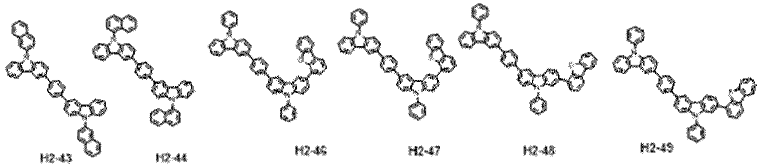

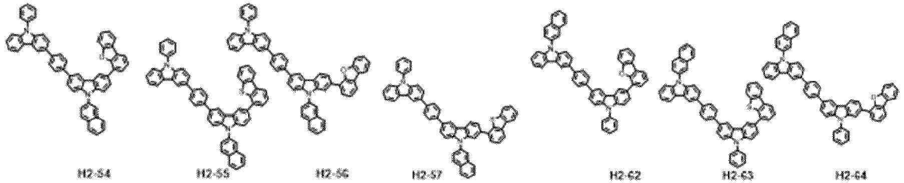

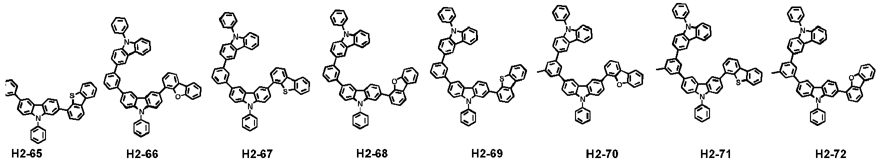

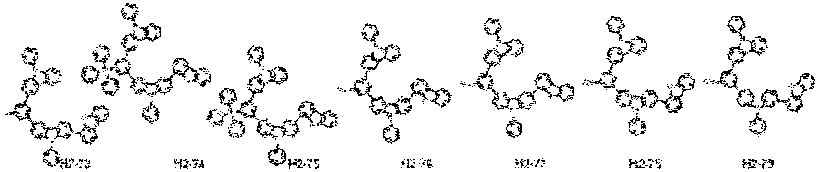

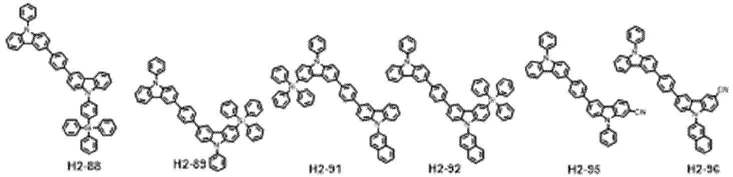

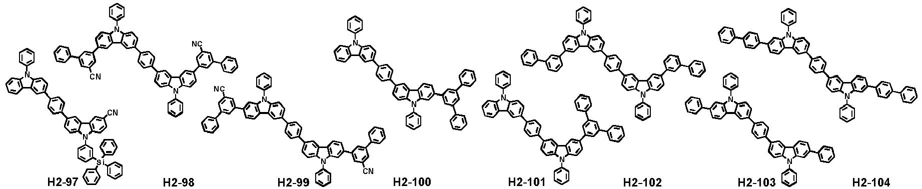

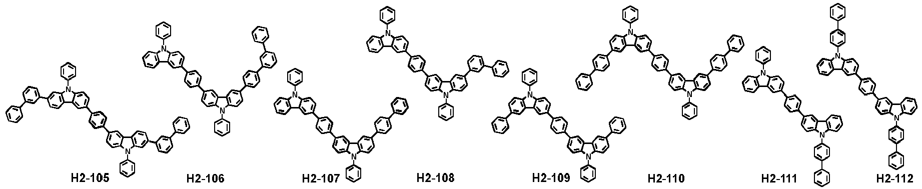

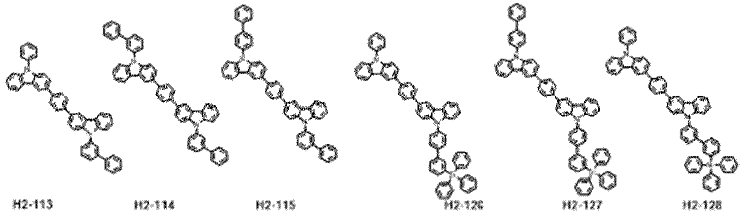

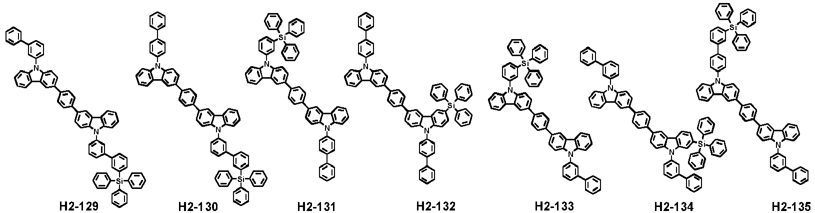

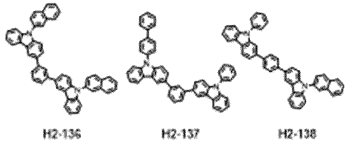

The organic electroluminescent device according to the present invention comprises an anode, a cathode, and at least one light-emitting layer between the anode and the cathode. The light-emitting layer comprises a host and a phosphorescent dopant. The host material comprises plural host compounds, at least a first host compound of the plural host compounds is represented by formula 1 having a structure of a nitrogen-containing heterocyclic linker bonded to a nitrogen atom of a carbazole of an indole-carbazole, indene-carbazole, benzofuran-carbazole, or benzothiophene-carbazole residue, and a second host compound is represented by formula 2 having a carbazole-aryl-carbazole or carbazole-carbazole structure.

The light-emitting layer is a layer from which light is emitted, and can be a single layer or a multi-layer of which two or more layers are stacked. In the light-emitting layer, it is preferable that the doping concentration of the dopant compound based on the host compound is less than 20 wt%.

The phosphorescent dopant material comprised in the organic electroluminescent device according to the present invention are not limited, but may be preferably selected from metallated complex compounds of iridium, osmium, copper, and platinum, more preferably selected from ortho-metallated complex compounds of iridium, osmium, copper and platinum, and even more preferably ortho-metallated iridium complex compounds.

The phosphorescent dopant is preferably selected from the compounds represented by the following formulas 101 to 103. 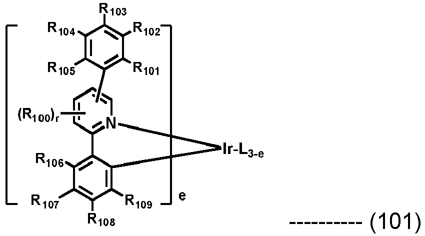 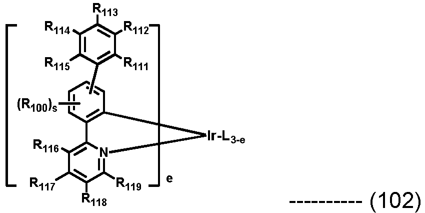 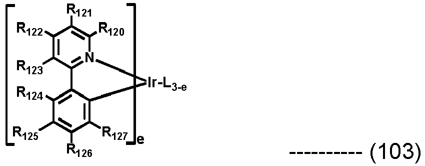
wherein L is selected from the following structures: 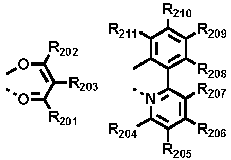 R₁₀₀ represents hydrogen, or a substituted or unsubstituted (C1-C30)alkyl;
R₁₀₁ to R₁₀₉ and R₁₁₁ to R₁₂₃ each independently represent hydrogen, deuterium, a halogen, a (C1-C30)alkyl unsubstituted or substituted with a halogen(s), a cyano, a substituted or unsubstituted (C1-C30)alkoxy, a substituted or unsubstituted (C3-C30)cycloalkyl, or a substituted or unsubstituted (C6-C30)aryl; R₁₂₀ to R₁₂₃ may be linked to an adjacent substituent to form a substituted or unsubstituted mono- or polycyclic, (C3-C30) alicyclic or aromatic ring, e.g., quinoline;
R₁₂₄ to R₁₂₇ each independently represent hydrogen, deuterium, a halogen, a substituted or unsubstituted (C1-C30)alkyl, or a substituted or unsubstituted (C6-C30)aryl; and where R₁₂₄ to R₁₂₇ are aryls, R₁₂₄ to R₁₂₇ may be linked to an adjacent substituent to form a substituted or unsubstituted mono- or polycyclic, (C3-C30) alicyclic or (hetero)aromatic ring, e.g., fluorene, dibenzothiophene, or dibenzofuran;
R₂₀₁ to R₂₁₁ each independently represent hydrogen, deuterium, a halogen, or a (C1-C30)alkyl unsubstituted or substituted with a halogen(s); R₂₀₈ to R₂₁₁ may be linked to an adjacent substituent to form a substituted or unsubstituted mono- or polycyclic, (C3-C30) alicyclic, aromatic, orheteroaromatic ring, e.g., fluorene, dibenzothiophene, or dibenzofuran;
r and s each independently represent an integer of 1 to 3; where r or s is an integer of 2 or more, each of R₁₀₀ may be the same or different; and
e represents an integer of 1 to 3.

Specifically, the phosphorescent dopant materials include the following:

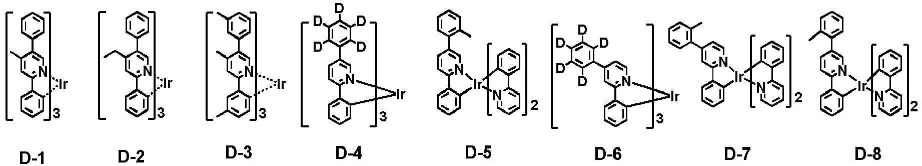

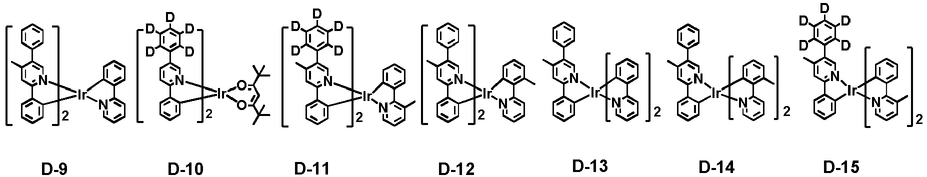

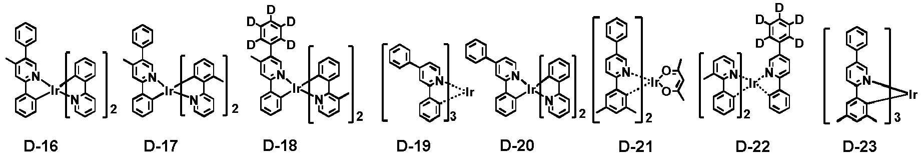

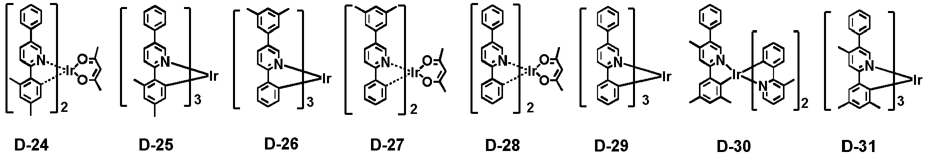

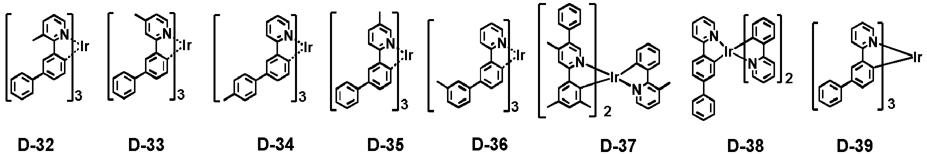

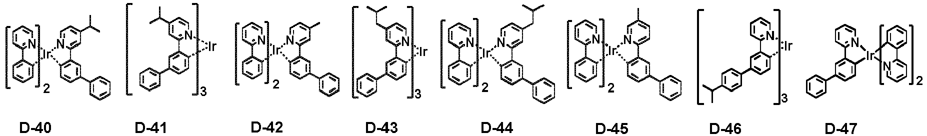

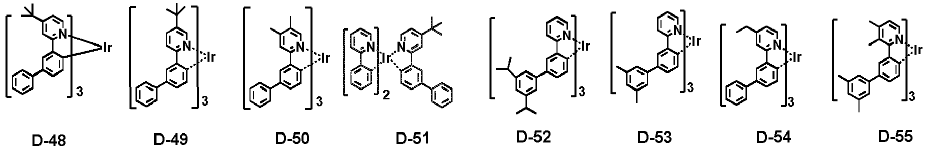

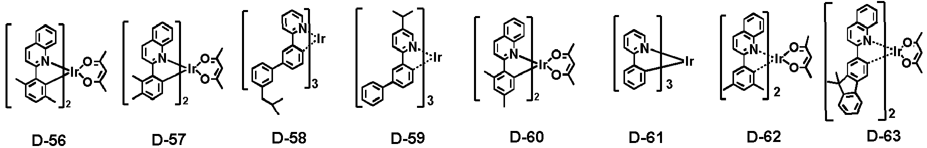

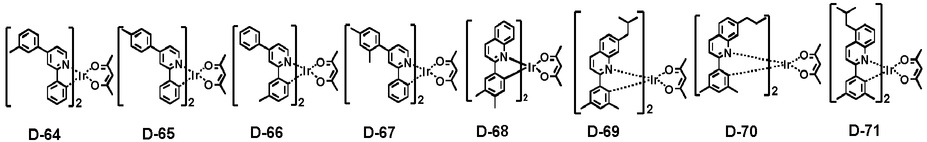

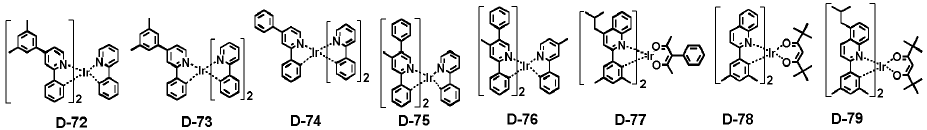

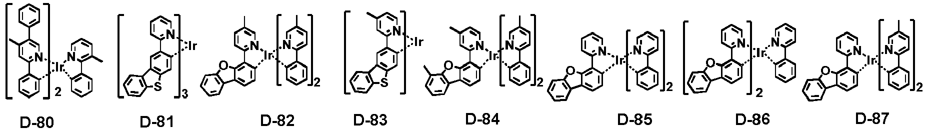

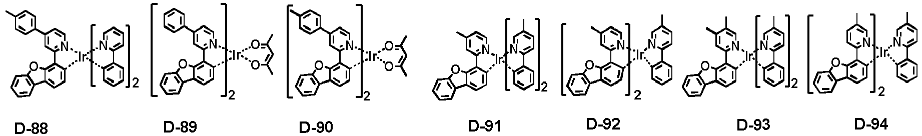

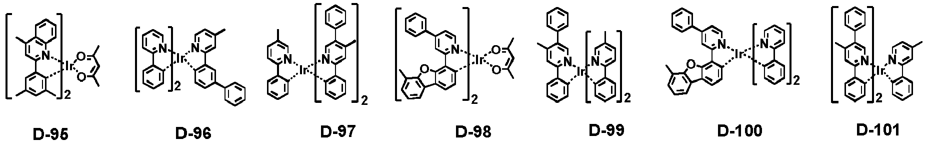

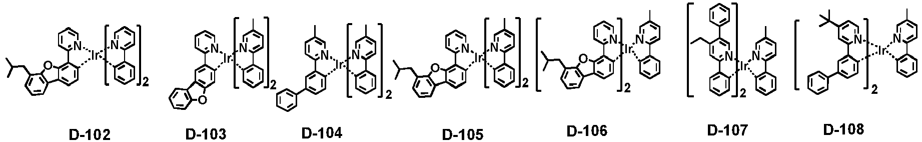

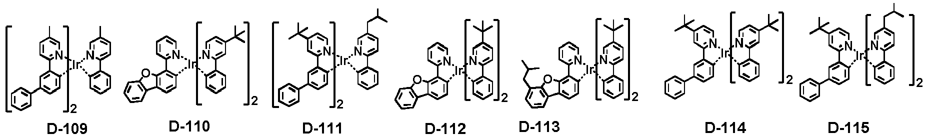

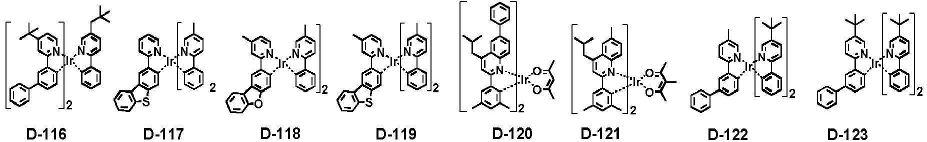

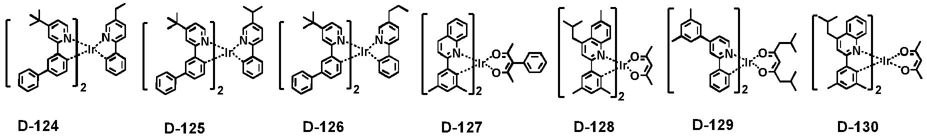

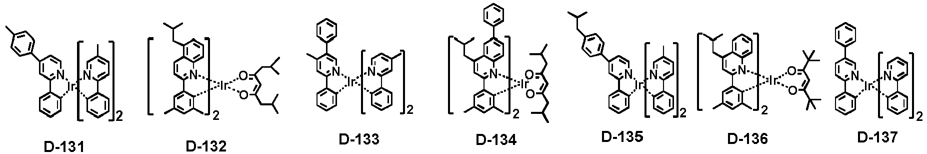

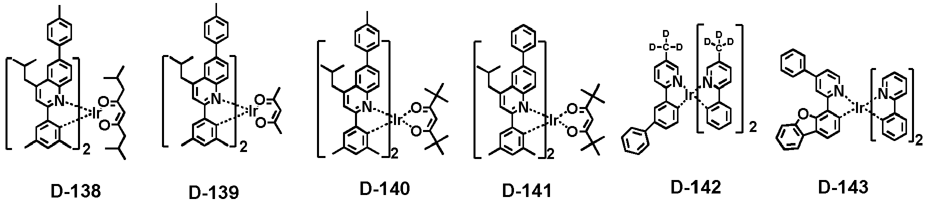

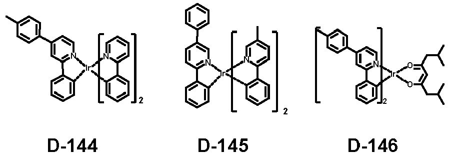

The organic electroluminescent device according to the present invention may further comprise at least one compound selected from the group consisting of arylamine-based compounds and styrylarylamine-based compounds in the organic layer.

In addition, in the organic electroluminescent device according to the present invention, the organic layer may further comprise at least one metal selected from the group consisting of metals of Group 1, metals of Group 2, transition metals of the 4^{th} period, transition metals of the 5^{th} period, lanthanides and organic metals of d-transition elements of the Periodic Table, or at least one complex compound comprising said metal.

According to the present invention, at least one layer (hereinafter, "a surface layer") is preferably placed on an inner surface(s) of one or both electrodes selected from a chalcogenide layer, a metal halide layer and a metal oxide layer. Specifically, a chalcogenide (including oxides) layer of silicon or aluminum is preferably placed on an anode surface of an electroluminescent medium layer, and a metal halide layer or a metal oxide layer is preferably placed on a cathode surface of an electroluminescent medium layer. Such a surface layer provides operation stability for the organic electroluminescent device. Preferably, said chalcogenide includes SiOₓ(1≤X≤52), AlOₓ(1≤X≤1.5), SiON, SiAlON, etc.; said metal halide includes LiF, MgF₂, CaF₂, a rare earth metal fluoride, etc.; and said metal oxide includes Cs₂O, Li₂O, MgO, SrO, BaO, CaO, etc.

Between the anode and the light-emitting layer, a hole injection layer, a hole transport layer, an electron blocking layer, or a combination thereof can be used. Multi-layers can be used for the hole injection layer in order to lower the hole injection barrier (or hole injection voltage) from the anode to the hole transport layer or the electron blocking layer. Two compounds can be simultaneously used in each layer. The hole transport layer and the electron blocking layer can also be formed of multi-layers.

Between the light-emitting layer and the cathode, a layer selected from an electron buffer layer, a hole blocking layer, an electron transport layer, or an electron injection layer, or formed by a combination thereof can be used. Multi-layers can be used for the electron buffer layer in order to control the injection of the electrons and enhance the interfacial characteristics between the light-emitting layer and the electron injection layer. Two compounds can be simultaneously used in each layer. The hole blocking layer and the electron transport layer can also be formed of multi-layers, and each layer can comprise two or more compounds.

In the organic electroluminescent device according to the present invention, a mixed region of an electron transport compound and a reductive dopant, or a mixed region of a hole transport compound and an oxidative dopant is preferably placed on at least one surface of a pair of electrodes. In this case, the electron transport compound is reduced to an anion, and thus it becomes easier to inject and transport electrons from the mixed region to an electroluminescent medium. Further, the hole transport compound is oxidized to a cation, and thus it becomes easier to inject and transport holes from the mixed region to the electroluminescent medium. Preferably, the oxidative dopant includes various Lewis acids and acceptor compounds; and the reductive dopant includes alkali metals, alkali metal compounds, alkaline earth metals, rare-earth metals, and mixtures thereof. A reductive dopant layer may be employed as a charge-generating layer to prepare an electroluminescent device having two or more electroluminescent layers and emitting white light.

In order to form each layer of the organic electroluminescent device of the present invention, dry film-forming methods such as vacuum evaporation, sputtering, plasma and ion plating methods, or wet film-forming methods such as spin coating, dip coating, and flow coating methods can be used. The first and second host compounds of the present invention may be co-evaporated or mixture-evaporated.

When using a wet film-forming method, a thin film can be formed by dissolving or diffusing materials forming each layer into any suitable solvent such as ethanol, chloroform, tetrahydrofuran, dioxane, etc. The solvent can be any solvent where the materials forming each layer can be dissolved or diffused, and where there are no problems in film-formation capability.

By using the organic electroluminescent device of the present invention, a display system or a lighting system can be produced.

Hereinafter, the luminescent properties of the device comprising the host compound of the present invention will be explained in detail with reference to the following examples.

### Device Example 1-1: Preparation of an OLED device wherein the first host compound and the second host compound of the present invention are co-evaporated

An OLED device was produced using the organic electroluminescent compound according to the present invention. A transparent electrode indium tin oxide (ITO) thin film (10 Ω/sq) on a glass substrate for an organic light-emitting diode (OLED) device (Geomatec) was subjected to an ultrasonic washing with acetone, ethanol, and distilled water, sequentially, and then was stored in isopropanol. The ITO substrate was then mounted on a substrate holder of a vacuum vapor depositing apparatus. Compound HI-1 was introduced into a cell of said vacuum vapor depositing apparatus, and then the pressure in the chamber of said apparatus was controlled to 10⁻⁶ torr. Thereafter, an electric current was applied to the cell to evaporate the above introduced material, thereby forming a hole injection layer having a thickness of 5 nm on the ITO substrate. Next, Compound HT-1 was introduced into another cell of said vacuum vapor depositing apparatus, and was evaporated by applying an electric current to the cell, thereby forming a first hole transport layer having a thickness of 95 nm on the hole injection layer. Compound HT-2 was then introduced into another cell of said vacuum vapor depositing apparatus, and was evaporated by applying an electric current to the cell, thereby forming a second hole transport layer having a thickness of 20 nm on the first hole transport layer. The first and second host compounds of Device Example 1-1 in Table 1 were introduced into two cells of said vacuum vapor depositing apparatus as hosts, and compound D-74 was introduced into another cell as a dopant. The two host materials were evaporated at the same rate of 1:1, while the dopant material was evaporated at a different rate from the host materials, so that the dopant was deposited in a doping amount of 12 wt% based on the total amount of the hosts and dopant to evaporate and form a light-emitting layer having a thickness of 30 nm on the second hole transport layer. Compound ET-1 was then introduced into another cell of the vacuum vapor depositing apparatus and evaporated to form an electron transport layer having a thickness of 35 nm on the light-emitting layer. After depositing compound EI-1 as an electron injection layer having a thickness of 2 nm on the electron transport layer, an Al cathode having a thickness of 80 nm was deposited by another vacuum vapor deposition apparatus. Thus, an OLED device was produced.

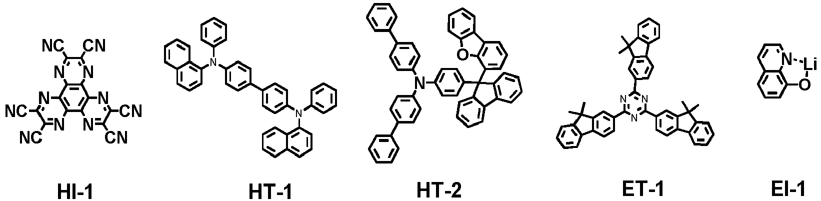

### Device Examples 1-2 to 1-9: Preparation of an OLED device wherein the first host compound and the second host compound of the present invention are co-evaporated

An OLED device was produced in the same manner as in Device Example 1-1, except for using the host and dopant of the light-emitting layer of Device Examples 1-2 to 1-9 in Table 1.

### Comparative Examples 1-1 to 1-6: Preparation of an OLED device comprising only the second host compound of the present invention as a host

An OLED device was produced in the same manner as in Device Example 1-1, except for using the host of the light-emitting layer of Comparative Examples 1-1 to 1-6 in Table 1.

### Comparative Example 1-7: Preparation of an OLED device comprising only the first host compound of the present invention as a host

An OLED device was produced in the same manner as in Device Example 1-1, except for using the host of the light-emitting layer of Comparative Example 1-7 in Table 1.

### Comparative Example 2-1: Preparation of an OLED device comprising the second host compound of the present invention and a host compound not according to the present invention as hosts

An OLED device was produced in the same manner as in Device Example 1-1, except for using the host of the light-emitting layer of Comparative Example 2-1 in Table 1.

A driving voltage at 10 mA/cm² and time taken to be reduced from 100% to 97% of the luminance at 10,000 nit and a constant current of the OLEDs produced in Device Examples 1-1 to 1-9, Comparative Examples 1-1 to 1-7, and Comparative Example 2-1 are shown in Table 1 below.

**[Table 1]**

| | **Host** | **Dopant** | **Driving voltage** | **Lifespan** |
|---|---|---|---|---|
| | | | **(V)** | **T97 (hr)** |
| **Device Example 1-1** | **H2-1: H1-1** | **D-74** | **3.7** | **82** |
| **Device Example 1-2** | **H2-37: H1-1** | **D-74** | **3.6** | **85** |
| **Device Example 1-3** | **H2-43: H1-1** | **D-74** | **3.6** | **75** |
| **Device Example 1-4** | **H2-138: H1-1** | **D-74** | **3.5** | **56** |
| **Device Example 1-5** | **H2-7: H1-1** | **D-74** | **3.6** | **84** |
| **Device Example 1-6** | **H2-36: H1-1** | **D-74** | **3.5** | **72** |
| **Device Example 1-7** | **H2-1: H1-1** | **D-144** | **3.8** | **82** |
| **Device Example 1-8** | **H2-1: H1-1** | **D-88** | **3.8** | **86** |
| **Device Example 1-9** | **H2-1: H1-1** | **D-137** | **3.6** | **82** |
| **Comparative Example 1-1** | **H2-1** | **D-74** | **4.5** | **21** |
| **Comparative Example 1-2** | **H2-37** | **D-74** | **5** | **16** |
| **Comparative Example 1-3** | **H2-43** | **D-74** | **4.6** | **14** |
| **Comparative Example 1-4** | **H2-138** | **D-74** | **5.2** | **1** |
| **Comparative Example 1-5** | **H2-7** | **D-74** | **4.7** | **19** |
| **Comparative Example 1-6** | **H2-36** | **D-74** | **4.7** | **20** |
| **Comparative Example 1-7** | **H1-1** | **D-74** | **3.9** | **55** |
| **Comparative Example 2-1** | **H2-1: H3** | **D-74** | **3.7** | **51** |

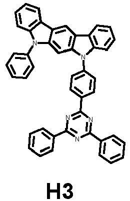

### Device Example 2: Preparation of an OLED device wherein the phosphorous host material and the second host compound of the present invention are co-evaporated (not forming part of the present invention)

An OLED device was produced using the organic electroluminescent compound according to the present invention. A transparent electrode indium tin oxide (ITO) thin film (10 Ω/sq) on a glass substrate for an organic light-emitting diode (OLED) device (Geomatec) was subjected to an ultrasonic washing with acetone, ethanol, and distilled water, sequentially, and then was stored in isopropanol. The ITO substrate was then mounted on a substrate holder of a vacuum vapor depositing apparatus. Compound HI-2 was introduced into a cell of said vacuum vapor depositing apparatus, and then the pressure in the chamber of said apparatus was controlled to 10⁻⁶ torr. Thereafter, an electric current was applied to the cell to evaporate the above introduced material, thereby forming a first hole injection layer having a thickness of 80 nm on the ITO substrate. Compound HI-1 was then introduced into another cell of said vacuum vapor depositing apparatus, and was evaporated by applying an electric current to the cell, thereby forming a second hole injection layer having a thickness of 5 nm on the first hole injection layer. Next, compound HT-3 was introduced into another cell of said vacuum vapor depositing apparatus, and was evaporated by applying an electric current to the cell, thereby forming a first hole transport layer having a thickness of 10 nm on the second hole injection layer. Compound HT-2 was then introduced into another cell of said vacuum vapor depositing apparatus, and was evaporated by applying an electric current to the cell, thereby forming a second hole transport layer having a thickness of 30 nm on the first hole transport layer. Compounds H1-71 and H2-141 were introduced into two cells of said vacuum vapor depositing apparatus as hosts, and compound D-102 was introduced into another cell as a dopant. The two host materials were evaporated at the same rate of 1:1, while the dopant material was evaporated at a different rate from the host materials, so that the dopant was deposited in a doping amount of 10 wt% based on the total amount of the hosts and dopant to evaporate and form a light-emitting layer having a thickness of 40 nm on the second hole transport layer. Compound ET-2 and compound EI-1 were then introduced into two cells of the vacuum vapor depositing apparatus, respectively, and evaporated at a rate of 4:6 to form an electron transport layer having a thickness of 35 nm on the light-emitting layer. After depositing compound EI-1 as an electron injection layer having a thickness of 2 nm on the electron transport layer, an Al cathode having a thickness of 80 nm was deposited by another vacuum vapor deposition apparatus. Thus, an OLED device was produced. All the materials used for producing the OLED device were those purified by vacuum sublimation at 10⁻⁶ torr.

The time taken to be reduced from 100% to 97% of the luminance at 15,000 nit and a constant current of the OLED is shown in Table 2 below.

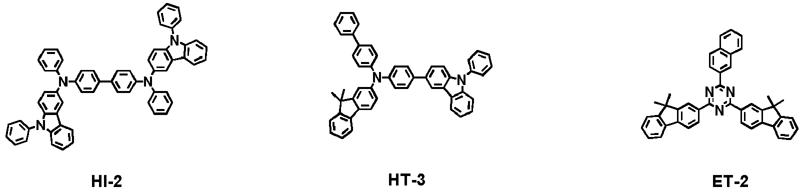

### Comparative Example 3: Preparation of an OLED device comprising a conventional phosphorous host material

An OLED device was produced in the same manner as in Device Example 2, except for using compound H3-3 instead of compound H1-71 for the host of the light-emitting layer.

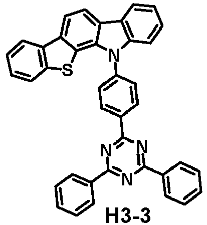

The time taken to be reduced from 100% to 97% of the luminance at 15,000 nit and a constant current of OLEDs are shown in Table 2 below.

**[Table 2]**

| | **Host** | **Dopant** | **Lifespan** |
|---|---|---|---|
| | | | **T97 [hr]** |
| **Device Example 2** | **H1-71:H2-141** | **D-102** | **41** |
| **Comparative Example 3** | **H3-3:H2-141** | **D-102** | **25** |

The organic electroluminescent device of the present invention comprises a light-emitting layer comprising plural host compounds and a phosphorescent dopant. At least a first host compound of the plural host compounds has a structure of a nitrogen-containing heterocyclic linker bonded to a nitrogen atom of a carbazole of an indole-carbazole, indene-carbazole, benzofuran-carbazole, or benzothiophene-carbazole residue, and a second host compound has a carbazole-aryl-carbazole or carbazole-carbazole structure. It is verified that the organic electroluminescent device of the present invention has an effect of significantly improved lifespan compared to conventional devices.

## Claims

1. An organic electroluminescent device comprising at least one light-emitting layer between an anode and a cathode, wherein the light-emitting layer comprises a host and a phosphorescent dopant; the host comprises plural host compounds; at least a first host compound of the plural host compounds is represented by the following formula 1; and a second host compound is represented by the following formula 2. 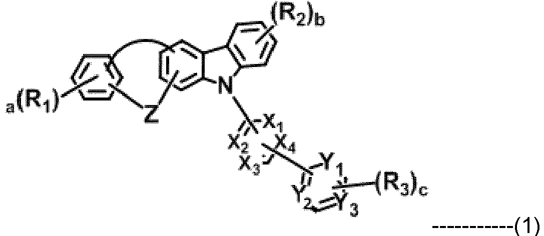 wherein
Z represents NR₄;
X₁ to X₄ each independently represent N or C(R₇), one or more of X₁ to X₄ is N;
Y₁ to Y₃ each independently represent N or C(R₈), two or more of Y₁ to Y₃ is N; R₁ to R₄, R₇ and R₈ each independently represent hydrogen, deuterium, a halogen, a cyano, a substituted or unsubstituted (C1-C30)alkyl, a substituted or unsubstituted (C6-C30)aryl, a substituted or unsubstituted 3- to 30-membered heteroaryl, a substituted or unsubstituted (C3-C30)cycloalkyl, a substituted or unsubstituted (C1-C30)alkoxy, a substituted or unsubstituted tri(C1-C30)alkylsilyl, a substituted or unsubstituted di(C1-C30)alkyl(C6-C30)arylsilyl, a substituted or unsubstituted (C1-C30)alkyldi(C6-C30)arylsilyl, a substituted or unsubstituted tri(C6-C30)arylsilyl, a substituted or unsubstituted mono- or di- (C1-C30)alkylamino, a substituted or unsubstituted mono- or di- (C6-C30)arylamino, or a substituted or unsubstituted (C1-C30)alkyl(C6-C30)arylamino; or may be linked to an adjacent substituent to form a substituted or unsubstituted mono- or polycyclic, (C3-C30) alicyclic or aromatic ring, whose carbon atom(s) may be replaced with at least one heteroatom selected from nitrogen, oxygen, and sulfur;
a and b each independently represent an integer of 1 to 4;
c represents 1 or 2;
where a, b, or c is an integer of 2 or more, each of R₁, each of R₂, or each of R₃ may be the same or different; and
the heteroaryl contains at least one heteroatom selected from B, N, O, S, Si, and P. 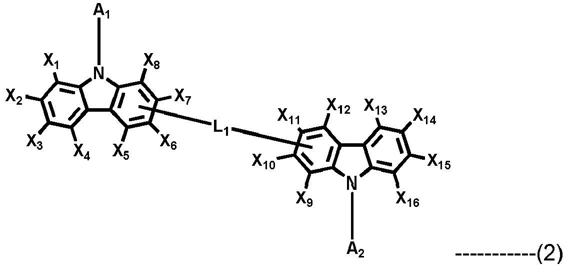 wherein
A₁ and A₂ each independently represent a (C6-C30)aryl unsubstituted or substituted with deuterium, a (C1-C30)alkyl, a (C6-C30)aryl or a tri(C6-C30)arylsilyl group;
L₁ represents a substituted or unsubstituted (C6-C30)arylene; and
X₁ to X₁₆ each independently represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, or a substituted or unsubstituted mono- or di- (C6-C30)arylamino; or adjacent substituents may be linked to each other to form a substituted or unsubstituted mono- or polycyclic, (C3-C30) alicyclic or aromatic ring, whose carbon atom(s) may be replaced with at least one heteroatom selected from nitrogen, oxygen, and sulfur.

2. The organic electroluminescent device according to claim 1, wherein formula 1 is represented by one of the following formulas 3 and 4: 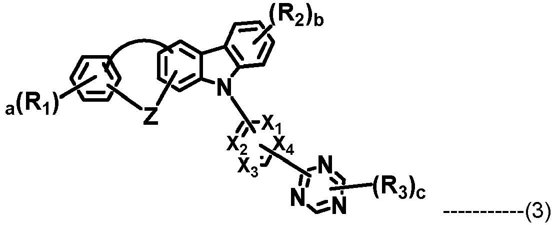 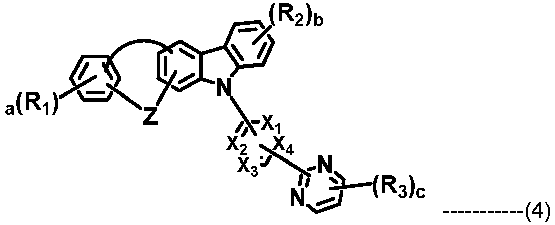 wherein
R₁ to R₃, X₁ to X₄, Z, and a to c are as defined in claim 1.

3. The organic electroluminescent device according to claim 1, wherein formula 1 is represented by one of the following formulas 5 to 7: 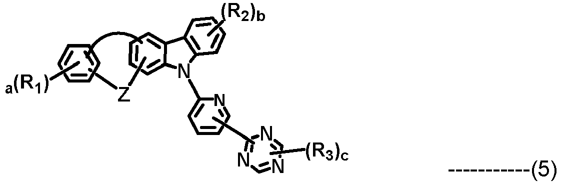 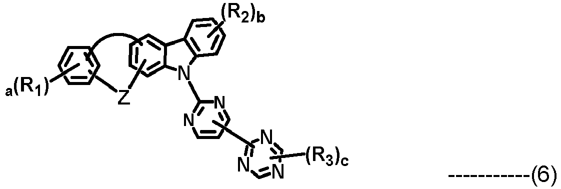 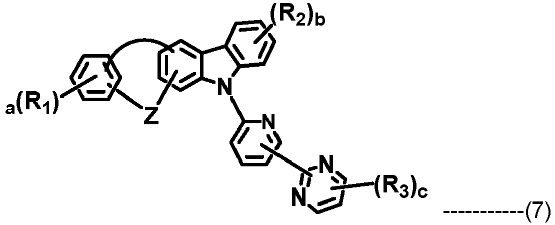 wherein
R₁ to R₃, Z, and a to c are as defined in claim 1.

4. The organic electroluminescent device according to claim 1, wherein the structure of 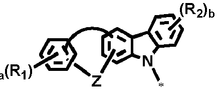 in formula 1 is represented by one of the following formulas 8 to 13: 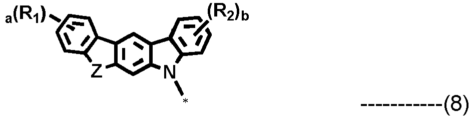 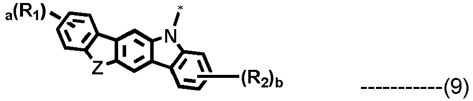 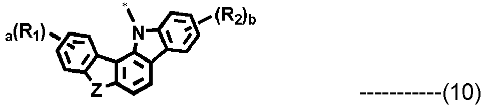 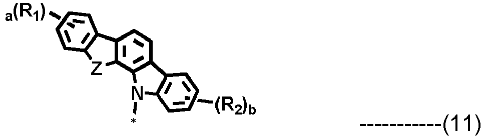 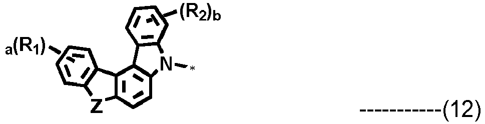 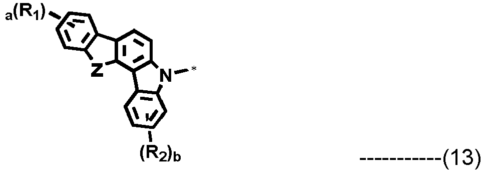 wherein
R₁, R₂, Z, a, and b are as defined in claim 1.

5. The organic electroluminescent device according to claim 1, wherein formula 2 is represented by one of the following formulas 14 to 17: 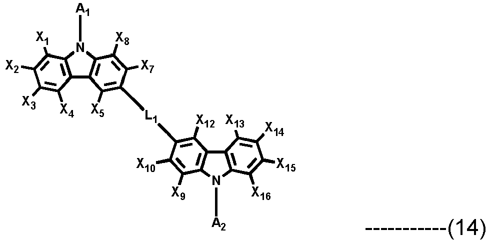 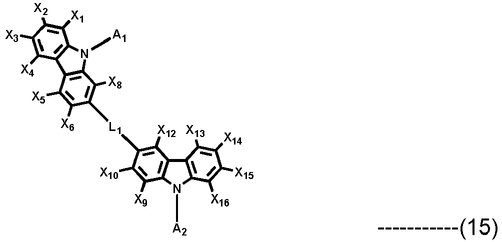 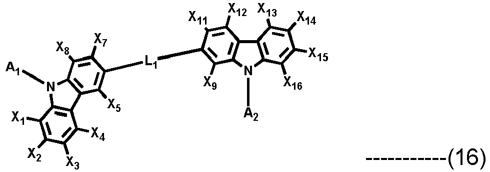 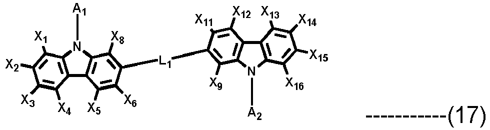 wherein
A₁, A₂, L₁, and X₁ to X₁₆ are as defined in claim 1.

6. The organic electroluminescent device according to claim 1, wherein in formula 2, A₁ and A₂ each independently are selected from the group consisting of phenyl, biphenyl, terphenyl, naphthyl, fluorenyl, benzofluorenyl, phenanthrenyl, anthracenyl, indenyl, triphenylenyl, pyrenyl, tetracenyl, perylenyl, chrysenyl, and fluoranthenyl.

7. The organic electroluminescent device according to claim 1, wherein in formula 2, L₁ represents one of the following formulas 18 to 30: 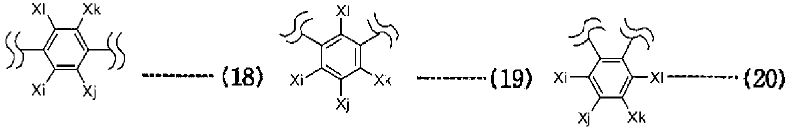 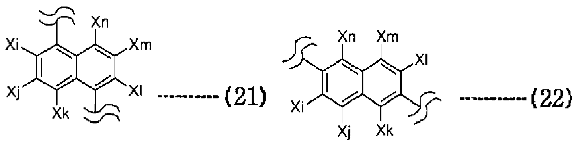 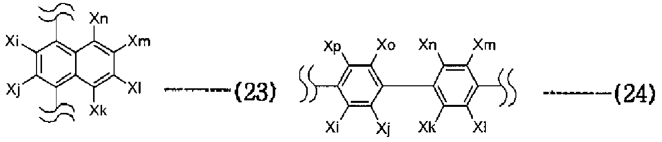 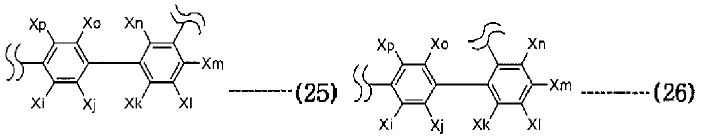 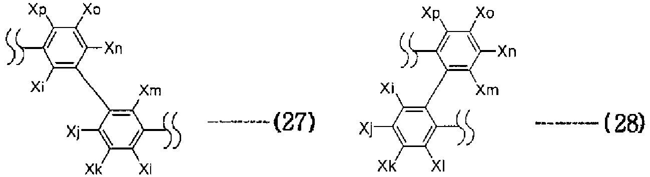 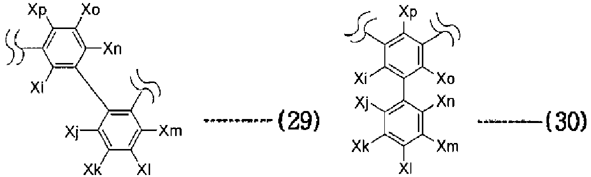 wherein
Xi to Xp each independently represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, or a substituted or unsubstituted mono- or di- (C6-C30)arylamino; or adjacent substituents may be linked to each other to form a substituted or unsubstituted, mono- or polycyclic, (C3-C30) alicyclic or aromatic ring, whose carbon atom(s) may be replaced with at least one heteroatom selected from nitrogen, oxygen, and sulfur.

8. The organic electroluminescent device according to claim 1, wherein in formulas 1 and 2, the substituents of the substituted alkyl, the substituted alkenyl, the substituted alkynyl, the substituted alkoxy, the substituted cycloalkyl, the substituted trialkylsilyl, the substituted dialkylarylsilyl, the substituted alkyldiarylsilyl, the substituted triarylsilyl, the substituted mono- or di- alkylamino, the substituted mono- or di- arylamino, the substituted alkylarylamino, the substituted aryl(ene), the substituted heteroaryl, and the substituted mono- or polycyclic, (C3-C30) alicyclic or aromatic ring in R₁ to R₄, R₇ and R₈, L₁, and X₁ to X₁₆ each independently are at least one selected from the group consisting of deuterium, a halogen, a cyano, a carboxyl, a nitro, a hydroxyl, a (C1-C30)alkyl, a halo(C1-C30)alkyl, a (C2-C30) alkenyl, a (C2-C30) alkynyl, a (C1-C30)alkoxy, a (C1-C30)alkylthio, a (C3-C30)cycloalkyl, a (C3-C30)cycloalkenyl, a 3- to 7-membered heterocycloalkyl, a (C6-C30)aryloxy, a (C6-C30)arylthio, a 3- to 30-membered heteroaryl unsubstituted or substituted with a (C6-C30)aryl, a (C6-C30)aryl unsubstituted or substituted with a 3- to 30-membered heteroaryl, a tri(C1-C30)alkylsilyl, a tri(C6-C30)arylsilyl, a di(C1-C30)alkyl(C6-C30)arylsilyl, a (C1-C30)alkyldi(C6-C30)arylsilyl, an amino, a mono- or di- (C1-C30)alkylamino, a mono- or di-(C6-C30)arylamino, a (C1-C30)alkyl(C6-C30)arylamino, a (C1-C30)alkylcarbonyl, a (C1-C30)alkoxycarbonyl, a (C6-C30)arylcarbonyl, a di(C6-C30)arylboronyl, a di(C1-C30)alkylboronyl, a (C1-C30)alkyl(C6-C30)arylboronyl, a (C6-C30)aryl(C1-C30)alkyl, and a (C1-C30)alkyl(C6-C30)aryl.

9. The organic electroluminescent device according to claim 1, wherein the first host compound represented by formula 1 is selected from the group consisting of:

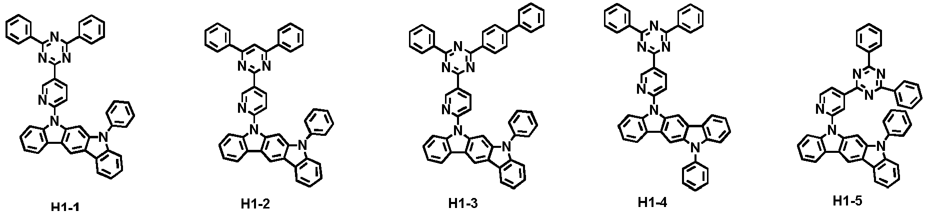

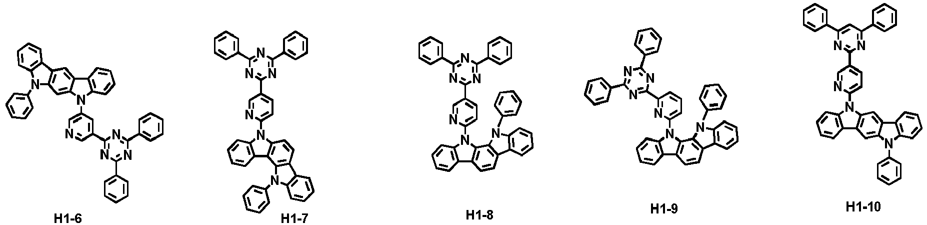

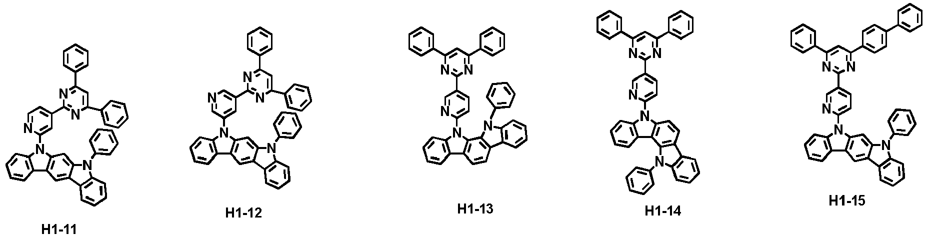

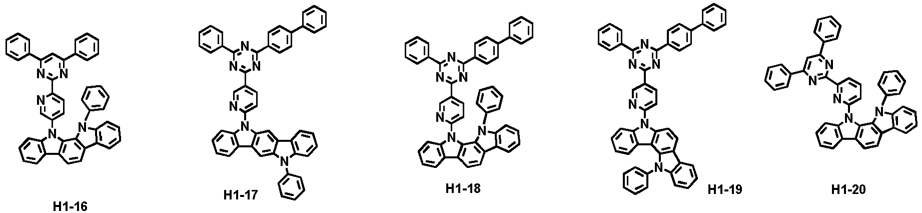

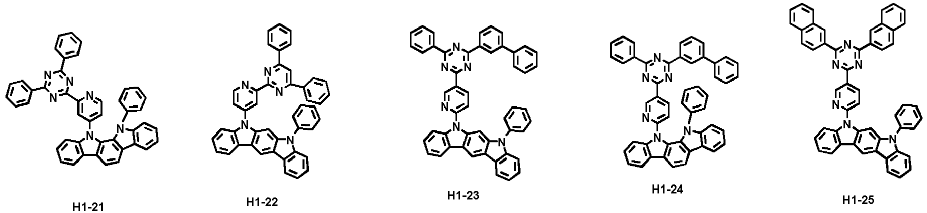

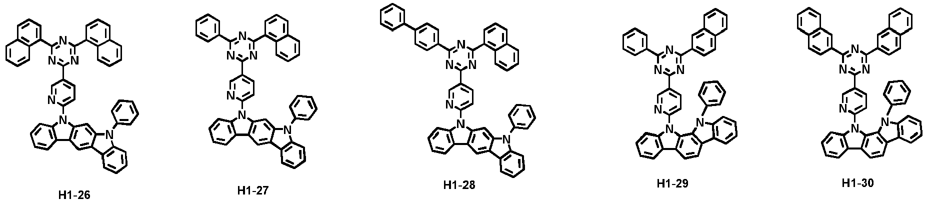

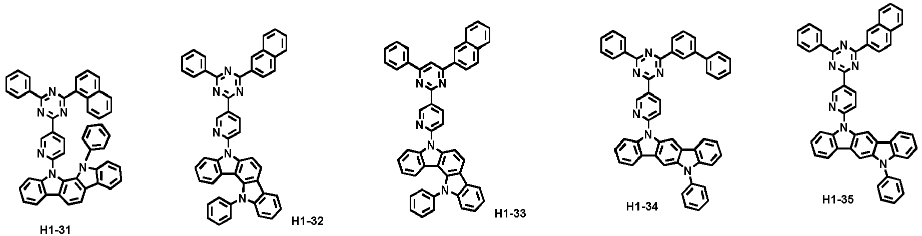

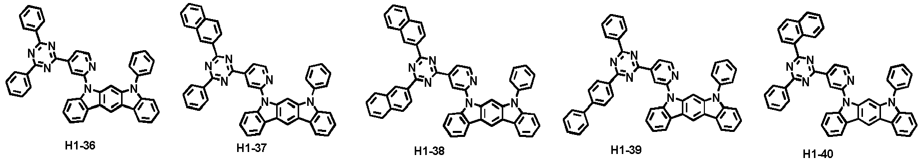

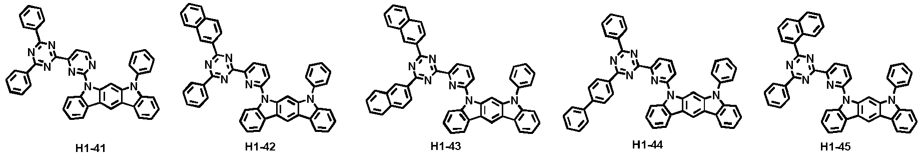

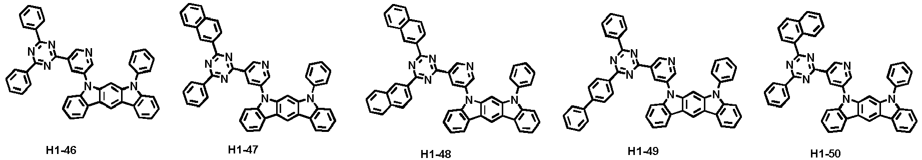

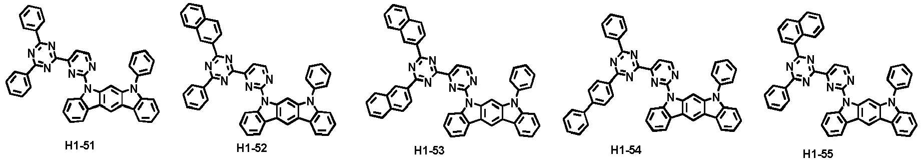

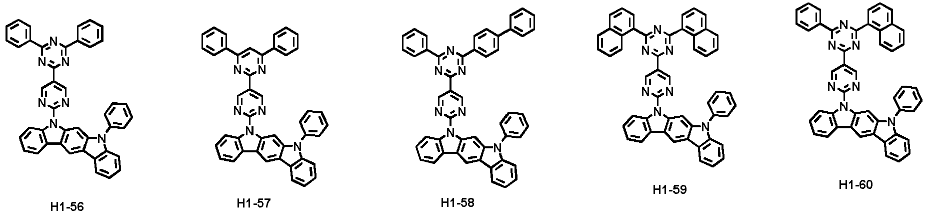

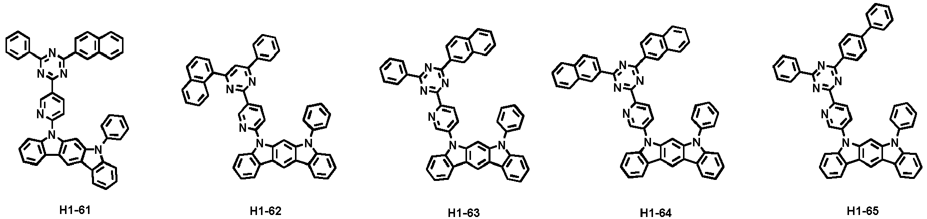

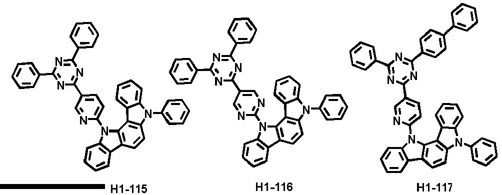

10. The organic electroluminescent device according to claim 1, wherein the second host compound represented by formula 2 is selected from the group consisting of:

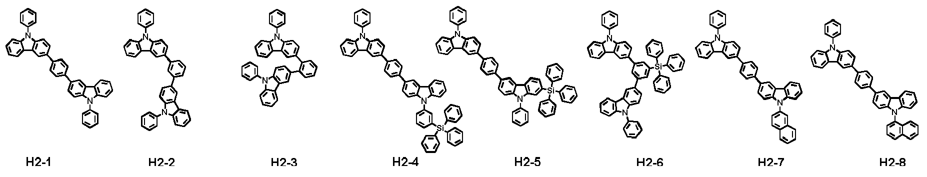

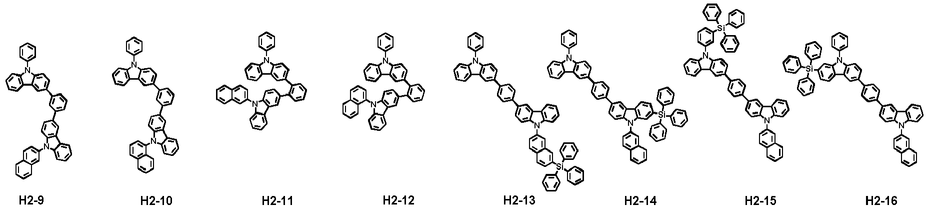

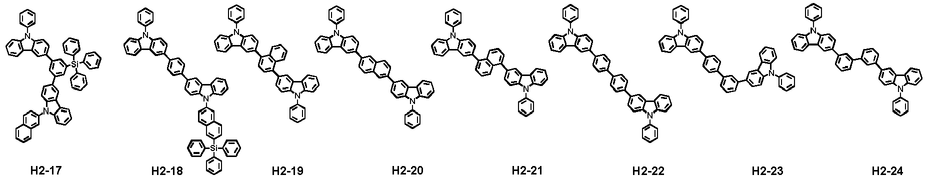

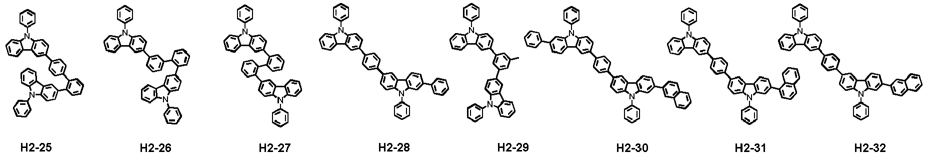

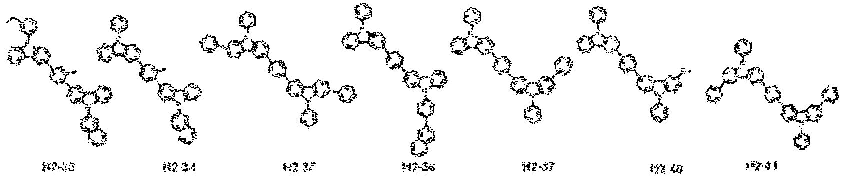

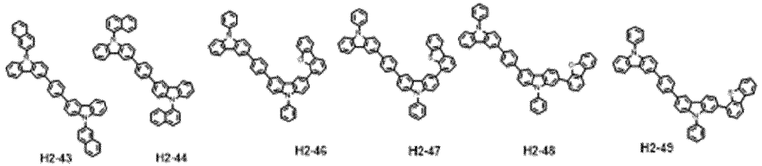

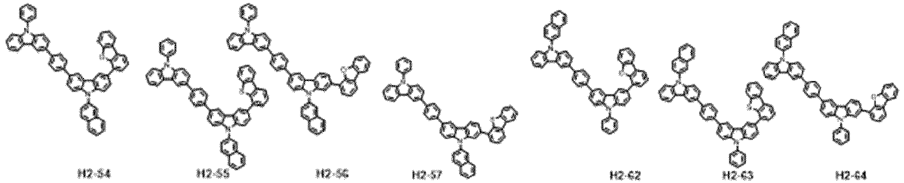

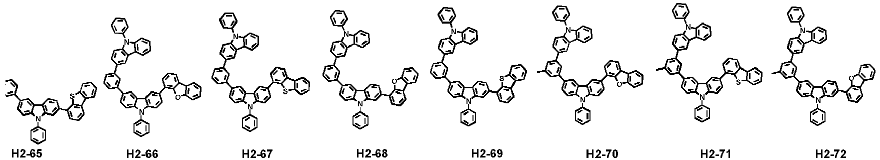

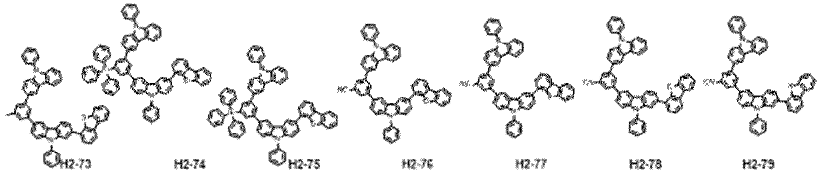

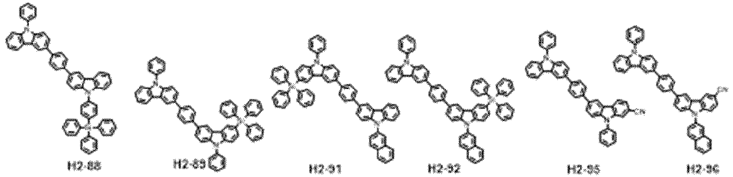

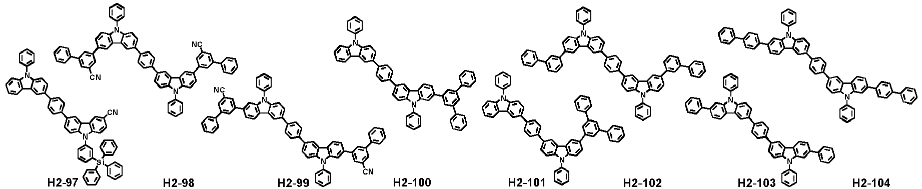

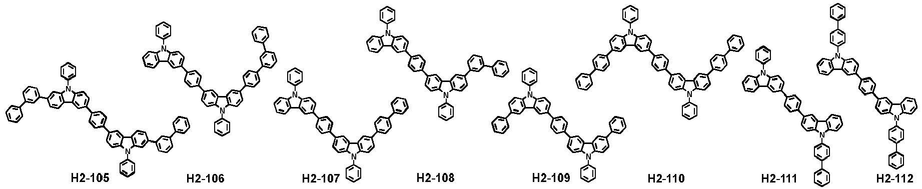

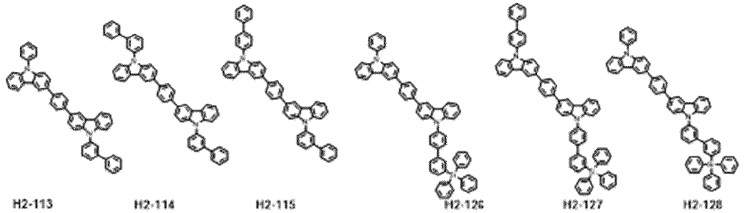

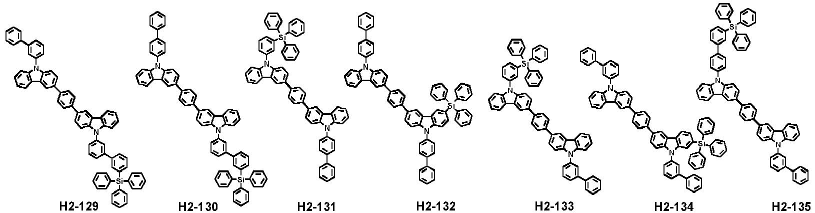

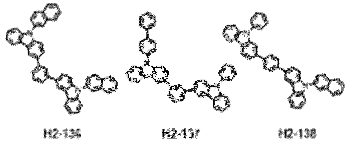

## Patentansprüche

1. Organische Elektrolumineszenz-Vorrichtung, umfassend mindestens eine Licht emittierende Schicht zwischen einer Anode und einer Kathode, wobei die Licht emittierende Schicht ein Grundmaterial und ein phosphoreszierendes Dotiermittel umfasst; wobei das Grundmaterial mehrere Grundmaterial-Verbindungen umfasst; wobei mindestens eine erste Grundmaterial-Verbindung der mehreren Grundmaterial-Verbindungen durch die folgende Formel 1 dargestellt wird; und eine zweite Grundmaterial-Verbindung durch die folgende Formel 2 dargestellt wird; 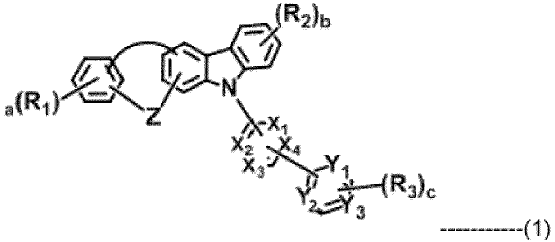 wobei
Z NR₄ darstellt;
X₁ bis X₄ jeweils unabhängig N oder C(R₇) darstellen, eines oder mehrere von X₁ bis X₄ N ist/sind;
Y₁ bis Y₃ jeweils unabhängig N oder C(R₈) darstellen, zwei oder mehr von Y₁ bis Y₃ N sind;
R₁ bis R₄, R₇ und R₈ jeweils unabhängig voneinander Wasserstoff, Deuterium, ein Halogen, ein Cyano, ein substituiertes oder unsubstituiertes (C1-C30)-Alkyl, ein substituiertes oder unsubstituiertes (C6-C30)-Aryl, ein substituiertes oder unsubstituiertes 3- bis 30-gliedriges Heteroaryl, ein substituiertes oder unsubstituiertes (C3-C30)-Cycloalkyl, ein substituiertes oder unsubstituiertes (C1-C30)-Alkoxy, ein substituiertes oder unsubstituiertes Tri-(C1-C30)-alkylsilyl, ein substituiertes oder unsubstituiertes Di-(C1-C30)-alkyl-(C6-C30)-arylsilyl, ein substituiertes oder unsubstituiertes (C1-C30)-Alkyldi-(C6-C30)-arylsilyl, ein substituiertes oder unsubstituiertes Tri-(C6-C30)-arylsilyl, ein substituiertes oder unsubstituiertes Mono- oder Di-(C1-C30)-alkylamino, ein substituiertes oder unsubstituiertes Mono- oder Di-(C6-C30)-arylamino oder substituiertes oder unsubstituiertes (C1-C30)-Alkyl-(C6-C30)-arylamino darstellen; oder mit einem angrenzenden Substituenten verknüpft sein können, um einen substituierten oder unsubstituierten mono- oder polycyclischen, (C3-C30)-alicyclischen oder aromatischen Ring zu bilden, dessen Kohlenstoffatom(e) durch mindestens ein Heteroatom ersetzt sein kann/können, das/die ausgewählt ist/sind aus Stickstoff, Sauerstoff und Schwefel;
a und b jeweils unabhängig eine ganze Zahl von 1 bis 4 darstellen;
c 1 oder 2 darstellt;
worin a, b oder c eine ganze Zahl von 2 oder mehr sind, jedes von R₁, jedes von R₂ oder jedes von R₃ gleich oder verschieden sein können; und
das Heteroaryl mindestens ein Heteroatom enthält, das ausgewählt ist aus B, N, O, S, Si und P, 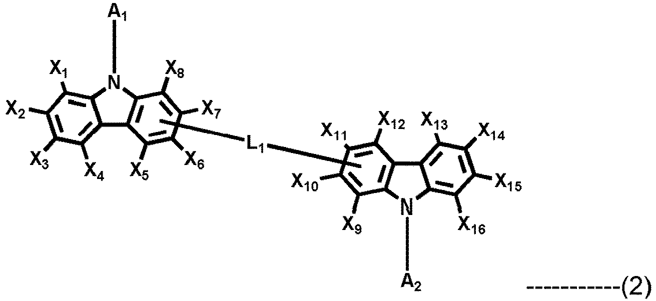 wobei
A₁ und A₂ jeweils unabhängig voneinander eine (C6-C30)-Aryl-, substituiert oder unsubstituiert mit Deuterium, eine (C1-C30)-Alkyl-, eine (C6-C30)-Aryl- oder eine Tri-(C6-C30)-arylsilyl-Gruppe darstellen;
L₁ ein substituiertes oder unsubstituiertes (C6-C30)-Arylen darstellt; und
X₁ bis X₁₆ jeweils unabhängig voneinander Wasserstoff, Deuterium, ein Halogen, ein Cyano, ein substituiertes oder unsubstituiertes (C1-C30)-Alkyl, ein substituiertes oder unsubstituiertes (C2-C30)-Alkenyl, ein substituiertes oder unsubstituiertes (C2-C30)-Alkinyl, ein substituiertes oder unsubstituiertes (C3-C30)-Cycloalkyl, ein substituiertes oder unsubstituiertes (C6-C60)-Aryl, ein substituiertes oder unsubstituiertes 3- bis 30-gliedriges Heteroaryl, ein substituiertes oder unsubstituiertes Tri-(C1-C30)-alkylsilyl, ein substituiertes oder unsubstituiertes Tri-(C6-C30)-arylsilyl, ein substituiertes oder unsubstituiertes Di-(C1-C30)-alkyl-(C6-C30)-arylsilyl oder ein substituiertes oder unsubstituiertes Mono- oder Di-(C6-C30)-arylamino darstellen; oder benachbarte Substituenten miteinander verbunden sein können, um einen substituierten oder unsubstituierten mono- oder polycyclischen, (C3-C30)-alicyclischen oder aromatischen Ring zu bilden, dessen Kohlenstoffatom(e) durch mindestens ein Heteroatom ersetzt sein kann/können, das ausgewählt ist aus Stickstoff, Sauerstoff und Schwefel.

2. Organische Elektrolumineszenz-Vorrichtung nach Anspruch 1, wobei Formel 1 dargestellt wird durch eine der folgenden Formeln 3 und 4: 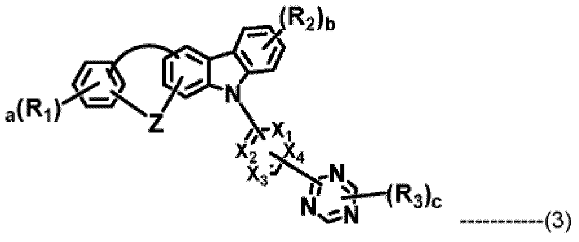 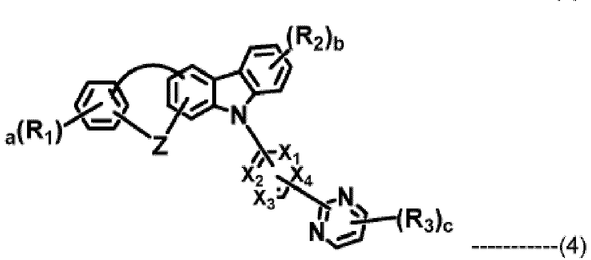 wobei R₁ bis R₃, X₁ bis X₄, Z und a bis c wie in Anspruch 1 festgelegt sind.

3. Organische Elektrolumineszenz-Vorrichtung nach Anspruch 1, wobei Formel 1 dargestellt wird durch eine der folgenden Formeln 5 bis 7: 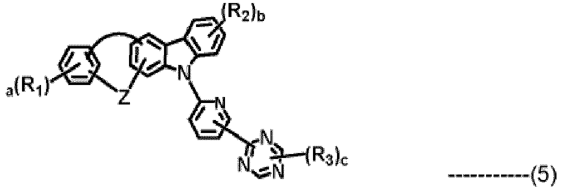 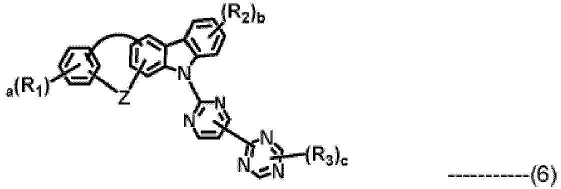 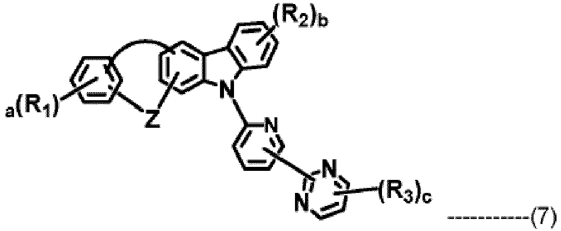 wobei
R₁ bis R₃, Z und a bis c wie in Anspruch 1 festgelegt sind.

4. Organische Elektrolumineszenz-Vorrichtung nach Anspruch 1, wobei die Struktur von 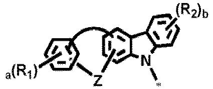 in Formel 1 dargestellt wird durch eine der folgenden Formeln 8 bis 13: 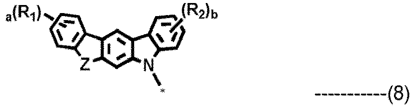 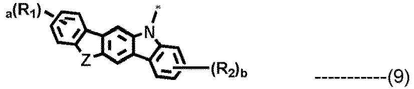 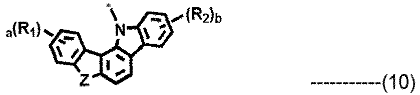 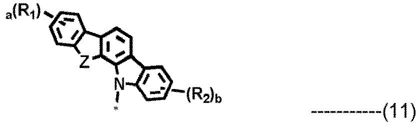 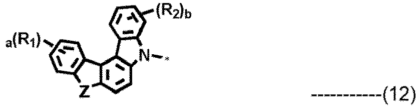 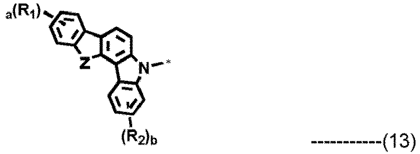 wobei
R₁, R₂, Z, a und b wie in Anspruch 1 festgelegt sind.

5. Organische Elektrolumineszenz-Vorrichtung nach Anspruch 1, wobei Formel 2 dargestellt wird durch eine der folgenden Formeln 14 bis 17: 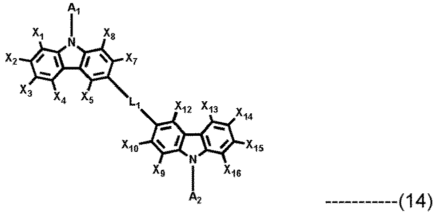 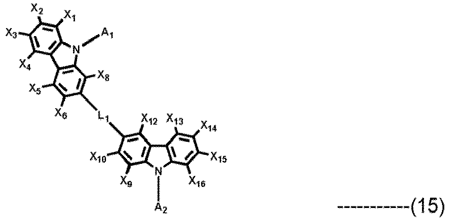 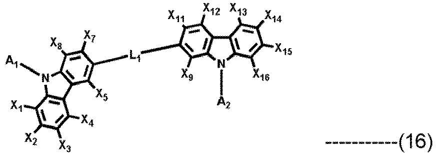 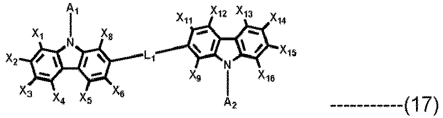 wobei
A₁, A₂, L₁ und X₁ bis X₁₆ wie in Anspruch 1 festgelegt sind.

6. Organische Elektrolumineszenz-Vorrichtung nach Anspruch 1, wobei in Formel 2
A₁ und A₂ jeweils unabhängig voneinander ausgewählt sind aus der Gruppe bestehend aus Phenyl, Biphenyl, Terphenyl, Naphthyl, Fluorenyl, Benzfluorenyl, Phenanthrenyl, Anthracenyl, Indenyl, Triphenylenyl, Pyrenyl, Tetracenyl. Perylenyl, Chrysenyl und Fluoranthenyl.

7. Organische Elektrolumineszenz-Vorrichtung nach Anspruch 1, wobei in Formel 2
L₁ eine der folgenden Formeln 18 bis 30 darstellt: 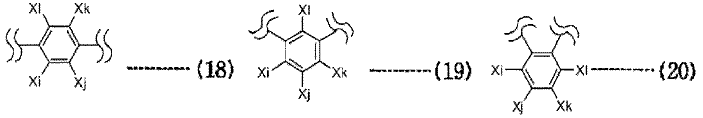 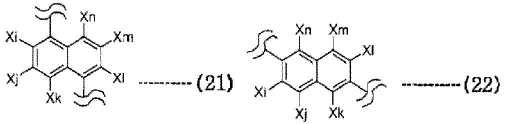 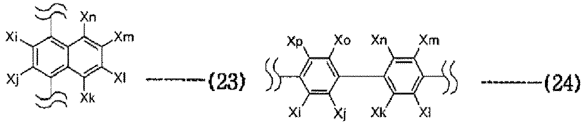 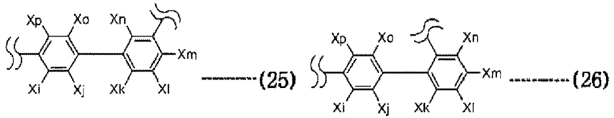 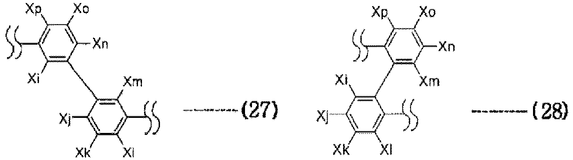 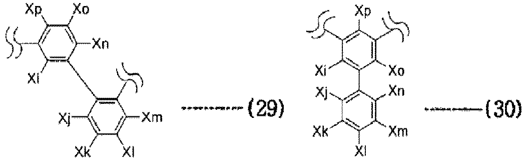 wobei
Xi bis Xp jeweils unabhängig voneinander Wasserstoff, Deuterium, ein Halogen, ein Cyano, ein substituiertes oder unsubstituiertes (C1-C30)-Alkyl, ein substituiertes oder unsubstituiertes (C2-C30)-Alkenyl, ein substituiertes oder unsubstituiertes (C2-C30)-Alkinyl, ein substituiertes oder unsubstituiertes (C3-C30)-Cycloalkyl, ein substituiertes oder unsubstituiertes (C6-C60)-Aryl, ein substituiertes oder unsubstituiertes 3- bis 30-gliedriges Heteroaryl, ein substituiertes oder unsubstituiertes Tri-(C1-C30)-alkylsilyl, ein substituiertes oder unsubstituiertes Tri-(C6-C30)-arylsilyl, ein substituiertes oder unsubstituiertes Di-(C1-C30)-alkyl-(C6-C30)-arylsilyl oder ein substituiertes oder unsubstituiertes Mono- oder Di-(C6-C30)-arylamino darstellen; oder angrenzende Substituenten miteinander verbunden sein können, um einen substituierten oder unsubstituierten, mono- oder polycyclischen (C3-C30)-alicyclischen oder aromatischen Ring zu bilden, dessen Kohlenstoffatom(e) durch mindestens ein Heteroatom ersetzt sein kann/können, das/die ausgewählt ist/sind aus Stickstoff, Sauerstoff, und Schwefel.

8. Organische Elektrolumineszenz-Vorrichtung nach Anspruch 1, wobei in den Formeln 1 und 2 die Substituenten des substituierten Alkyls, des substituierten Alkenyls, des substituierten Alkinyls, des substituierten Alkoxys, des substituierten Cycloalkyls, des substituierten Trialkylsilyls, des substituierten Dialkylarylsilyls, des substituierten Alkylarylsilyls, des substituierten Triarylsilyls, des substituierten Mono- oder Dialkylaminos, des substituierten Mono- oder Diarylaminos, des substituierten Alkylarylaminos, des substituierten Aryl(en), des substituierten Heteroaryls und des substituierten mono- oder polycyclischen (C3-C30)-alicyclischen oder aromatischen Rings in R₁ bis R₄, R₇ und R₈, L₁ und X₁ bis X₁₆ jeweils unabhängig voneinander mindestens eines sind, das ausgewählt ist aus der Gruppe bestehend aus Deuterium, einem Halogen, einem Cyano, einem Carboxyl, einem Nitro, einem Hydroxyl, einem (C1-C30)-Alkyl, einem Halogen-(C1-C30)-alkyl, einem (C2-C30)-Alkenyl, einem (C2-C30)-Alkinyl, einem (C1-C30)-Alkoxy, einem (C1-C30)-Alkylthio, einem (C3-C30)-Cycloalkyl, einem (C3-C30)-Cycloalkenyl, einem 3- bis 7-gliedrigen Heterocycloalkyl, einem (C6-C30)-Aryloxy einem (C6-C30)-Arylthio, einem 3- bis 30-gliedrigen Heteroaryl, das unsubstituiert oder mit einem (C6-C30)-Aryl substituiert ist, einem (C6-C30)-Aryl, das unsubstituiert oder mit einem 3- bis 30-gliedrigen Heteroaryl substituiert ist, einem Tri-(C1-C30)-alkylsilyl, einem Tri-(C6-C30)-arylsilyl, einem Di-(C1-C30)-alkyl-(C6-C30)-arylsilyl, einem (C1-C30)-Alkyl-di-(C6-C30)-arylsilyl, einem Amino, einem Mono- oder Di-(C1-C30)-alkylamino, einem Mono- oder Di-(C6-C30)-arylamino, einem (C1-C30)-Alkyl-(C6-C30)-arylamino, einem (C1-C30)-Alkylcarbonyl, einem (C1-C30)-Alkoxycarbonyl, einem (C6-C30)-Arylcarbonyl, einem Di-(C6-C30)-Arylboronyl, einem Di-(C1-C30)-alkylboronyl, einem (C1-C30)-Alkyl-(C6-C30)-arylboronyl, einem (C6-C30)-Aryl-(C1-C30)-alkyl und einem (C1-C30)-Alkyl-(C6-C30)-aryl.

9. Organische Elektrolumineszenz-Vorrichtung nach Anspruch 1, wobei die erste Grundmaterial-Verbindung, die dargestellt wird durch Formel 1, ausgewählt ist aus der Gruppe bestehend aus:

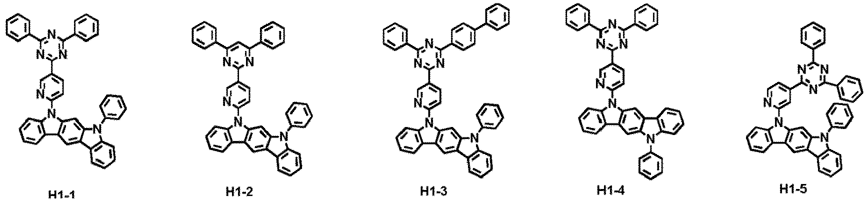

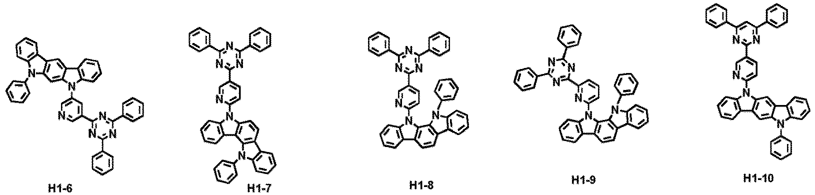

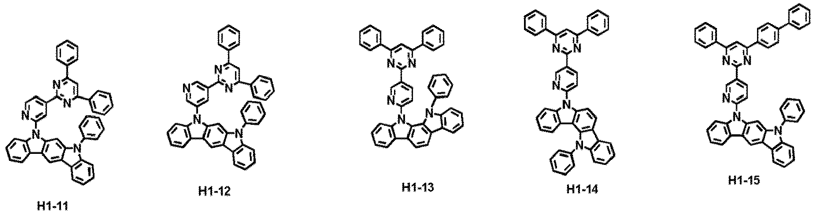

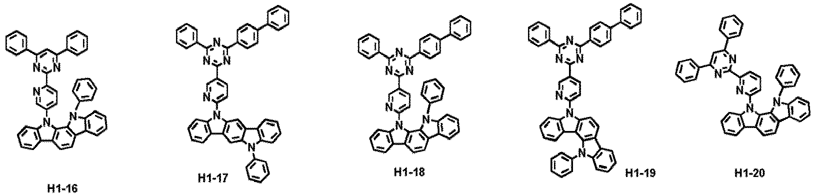

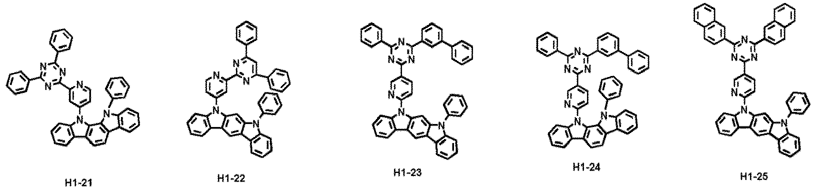

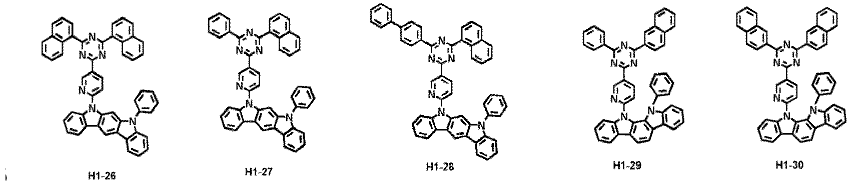

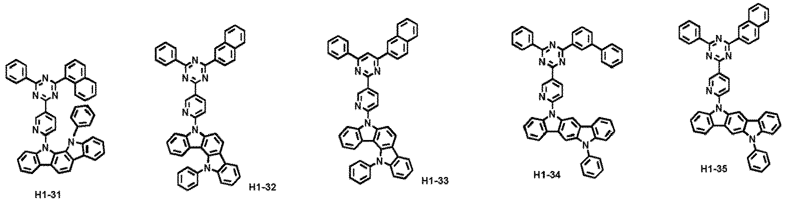

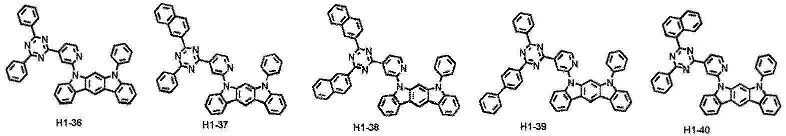

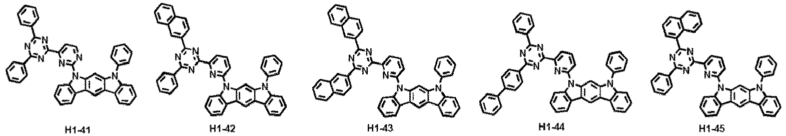

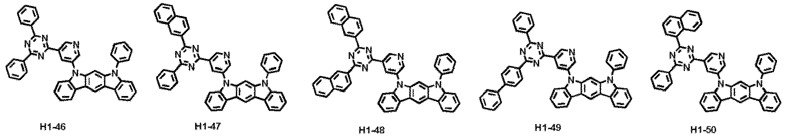

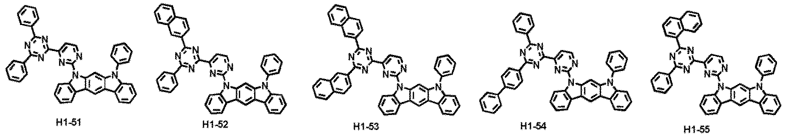

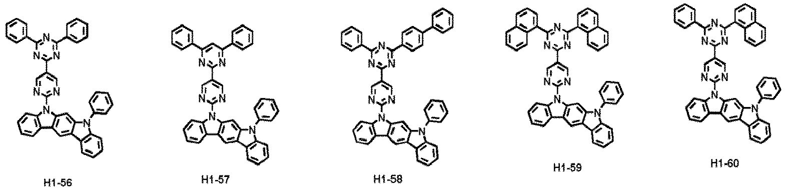

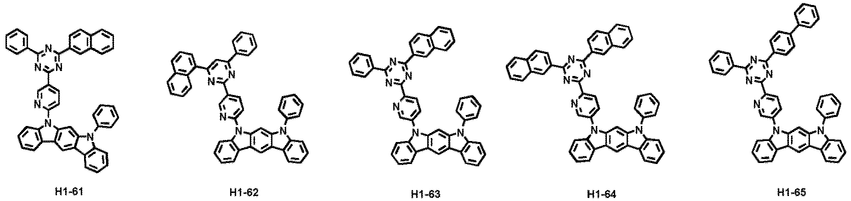

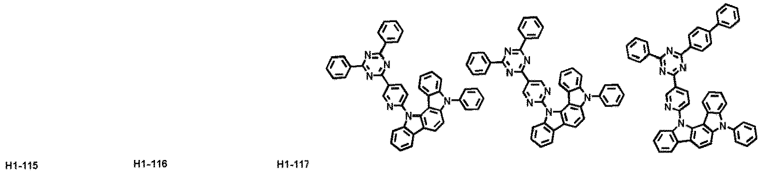

10. Organische Elektrolumineszenz-Vorrichtung nach Anspruch 1, wobei die zweite Grundmaterial-Verbindung, die dargestellt wird durch Formel 2, ausgewählt ist aus der Gruppe bestehend aus:

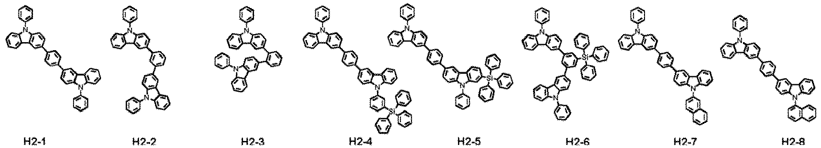

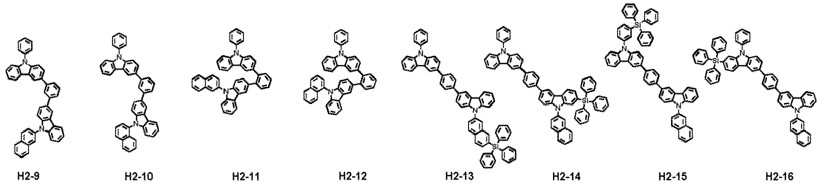

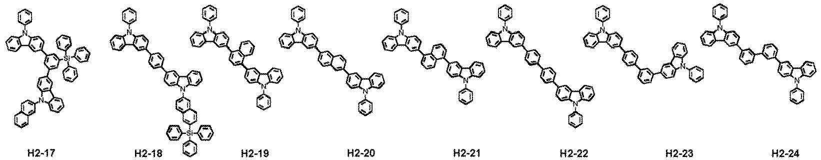

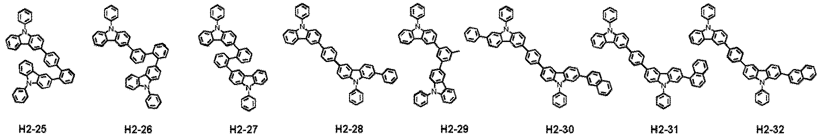

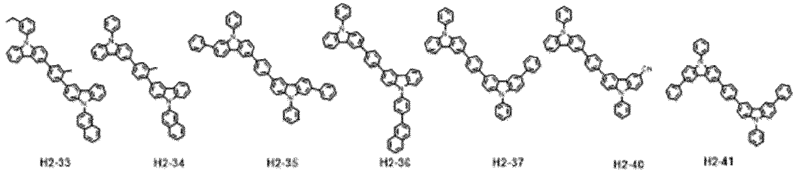

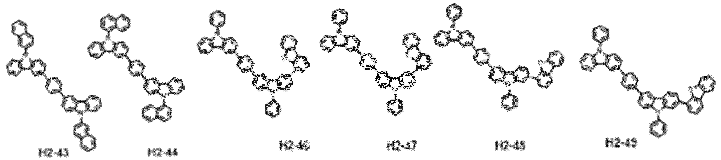

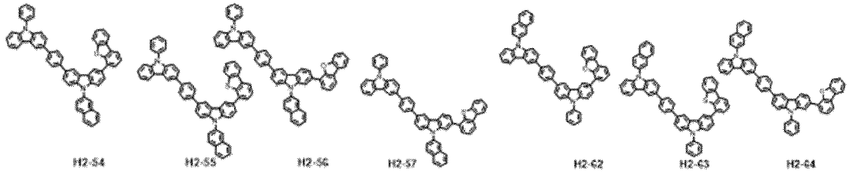

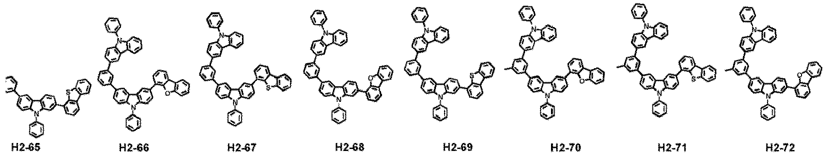

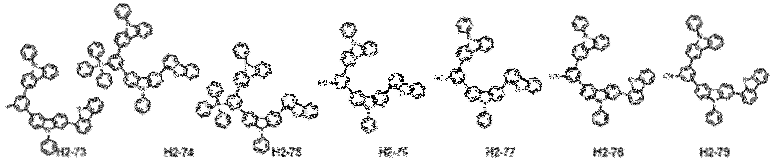

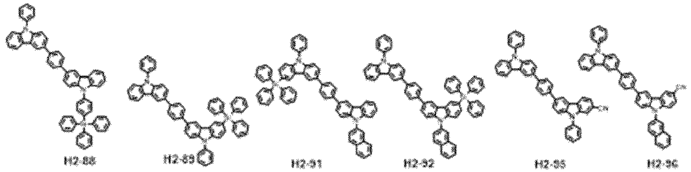

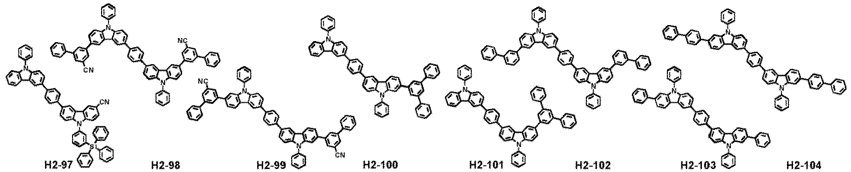

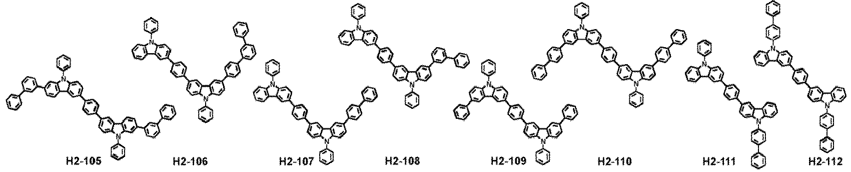

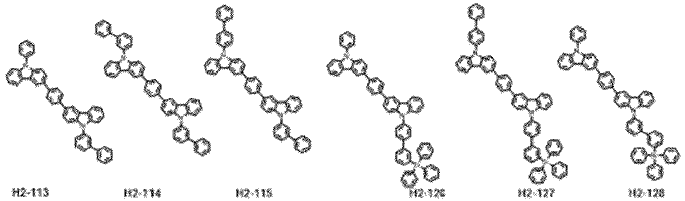

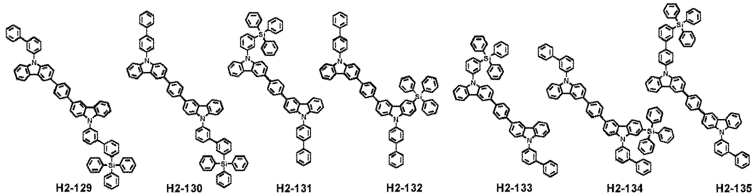

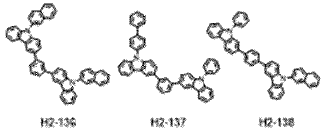

## Revendications

1. Dispositif électroluminescent organique comprenant au moins une couche luminescente entre une anode et une cathode, dans lequel la couche luminescente comprend un hôte et un dopant phosphorescent; l'hôte comprend de multiples composés hôtes; au moins un premier composé hôte des multiples composés hôtes est représenté par la formule 1 suivante; et un deuxième composé hôte est représenté par la formule 2 suivante. 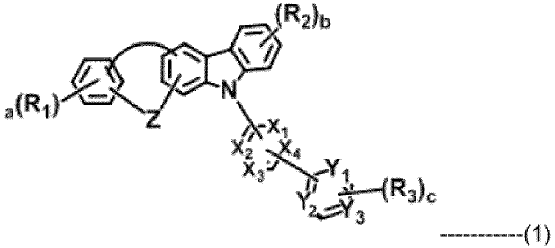 dans lequel
Z représente NR₄;
X₁ à X₄ représentent chacun indépendamment N ou C(R₇), un ou plusieurs de X₁ à X₄ est/sont N;
Y₁ à Y₃ représentent chacun indépendamment N ou C(R₈), deux de Y₁ à Y₃ ou plus sont N;
R₁ à R₄, R₇ et R₈ représentent chacun indépendamment de l'hydrogène, du deutérium, un halogène, un cyano, un alkyle (C1-C30) substitué ou non substitué, un aryle (C6-C30) substitué ou non substitué, un hétéroaryle à 3 à 30 chaînons substitué ou non substitué, un cycloalkyle (C3-C30) substitué ou non substitué, un alcoxy (C1-C30) substitué ou non substitué, un trialkyl(C1-C30)silyle substitué ou non substitué, un dialkyl(C1-C30)aryl(C6-C30)silyle substitué ou non substitué, un alkyl(C1-C30)diaryl(C6-C30)silyle substitué ou non substitué, un triaryl(C6-C30)silyle substitué ou non substitué, un mono ou dialkyl(C1-C30)amino substitué ou non substitué, un mono ou diaryl(C6-C30)amino substitué ou non substitué ou un alkyl(C1-C30)aryl(C6-C30)amino substitué ou non substitué, ou ils peuvent être liés à un substituant adjacent pour former un cycle alicyclique ou aromatique (C3-C30), mono ou polycyclique, dont l'atome(les atomes) de carbone peut(peuvent) être remplacé(s) par au moins un hétéroatome sélectionné parmi azote, oxygène et soufre;
a et b représentent chacun indépendamment un entier de 1 à 4;
c représente 1 ou 2;
où a, b ou c est un entier de 2 ou plus, chacun de R₁, chacun de R₂ ou chacun de R₃ pouvant être les mêmes ou différents; et
l'hétéroaryle contient au moins un hétéroatome sélectionné parmi B, N, O, S, Si et P, 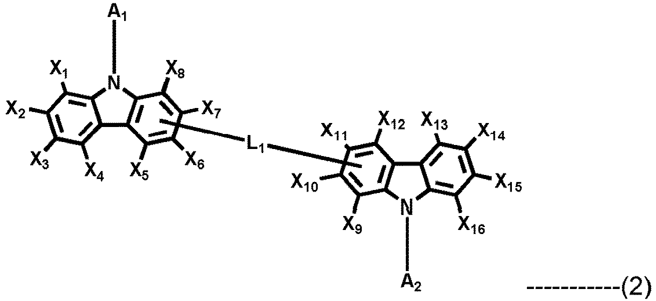 dans lequel
A₁ et A₂ représentent chacun indépendamment un groupe aryle (C6-C30) substitué ou non substitué par deutérium, alkyle (C1-C30), aryle (C6-C30) ou triaryl(C6-C30)silyle;
L₁ représente un arylène (C6-C30) substitué ou non substitué; et
X₁ à X₁₆ représentent chacun indépendamment de l'hydrogène, du deutérium, un halogène, un cyano, un alkyle (C1-C30) substitué ou non substitué, un alcényle (C2-C30) substitué ou non substitué, un alcynyle (C2-C30) substitué ou non substitué, un cycloalkyle (C3-C30) substitué ou non substitué, un aryle (C6-C60) substitué ou non substitué, un hétéroaryle à 3 à 30 chaînons substitué ou non substitué, un trialkyl(C1-C30)silyle substitué ou non substitué, un triaryl(C6-C30)silyle substitué ou non substitué, un dialkyl(C1-C30)aryl(C6-C30)silyle substitué ou non substitué, ou un mono ou diaryl(C6-C30)amino substitué ou non substitué, ou des substituants adjacents peuvent être liés les uns aux autres pour former un cycle alicyclique ou aromatique (C3-C30), mono ou polycyclique, substitué ou non substitué, dont l'atome(les atomes) de carbone peut(peuvent) être remplacé(s) par au moins un hétéroatome sélectionné parmi azote, oxygène et soufre.

2. Dispositif électroluminescent organique selon la revendication 1, dans lequel la formule 1 est représentée par l'une des formules 3 et 4 suivantes : 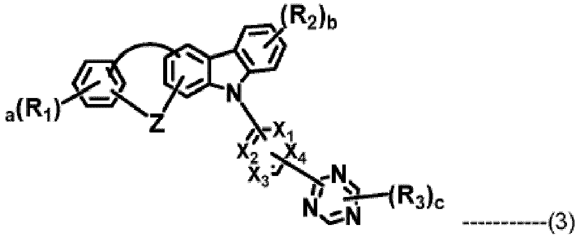 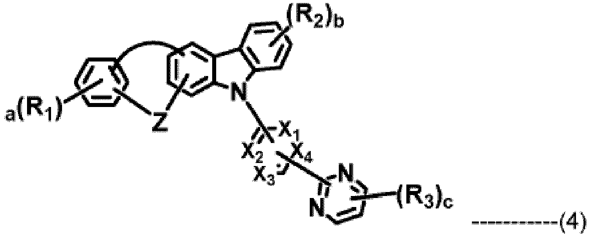 dans lequel
R₁ à R₃, X₁ à X₄, Z et a à c sont tels que définis selon la revendication 1.

3. Dispositif électroluminescent organique selon la revendication 1, dans lequel la formule 1 est représentée par l'une des formules 5 à 7 suivantes : 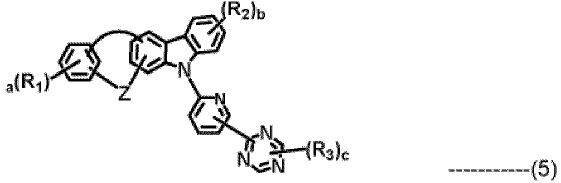 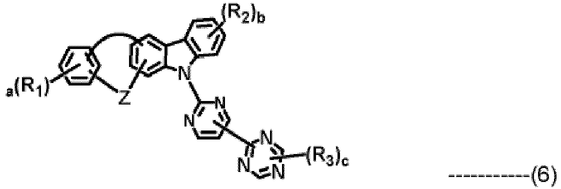 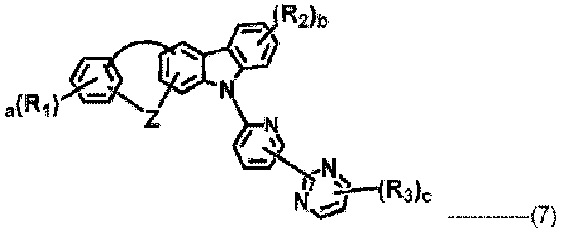 dans lequel
R₁ à R₃, Z et a à c sont tels que définis selon la revendication 1.

4. Dispositif électroluminescent organique selon la revendication 1, dans lequel la structure de 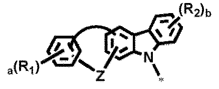 dans la formule 1 est représentée par l'une des formules 8 à 13 suivantes : 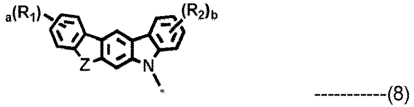 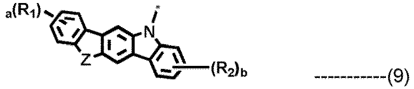 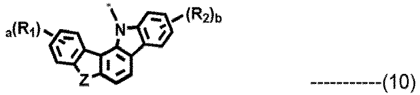 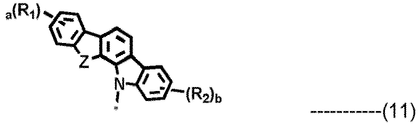 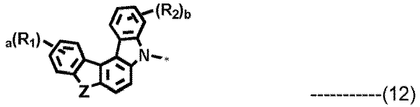 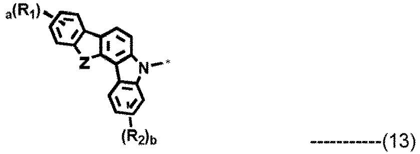 dans lequel
R₁, R₂, Z, a et b sont tels que définis selon la revendication 1.

5. Dispositif électroluminescent organique selon la revendication 1, dans lequel la formule 2 est représentée par l'une des formules 14 à 17 suivantes : 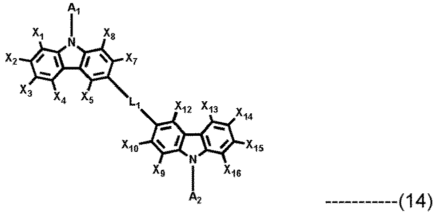 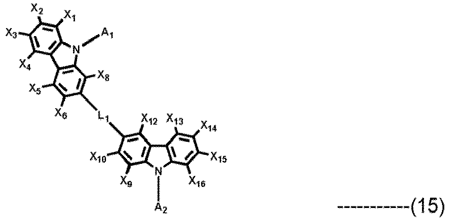 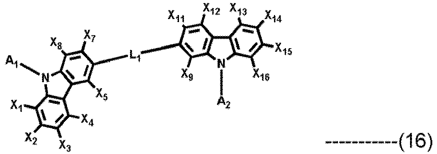 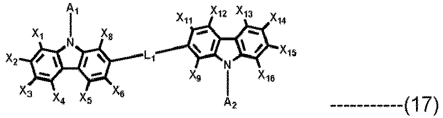 dans lequel
A₁, A₂, L₁ et X₁ à X₁₆ sont tels que définis selon la revendication 1.

6. Dispositif électroluminescent organique selon la revendication 1, dans lequel, dans la formule 2,
A₁ et A₂ sont sélectionnés chacun indépendamment parmi le groupe constitué de phényle, biphényle, terphényle, naphtyle, fluorényle, benzofluorényle, phénanthrényle, anthracényle, indényle, triphénylényle, pyrényle, tétracényle, pérylényle, chrysényle et fluoranthényle.

7. Dispositif électroluminescent organique selon la revendication 1, dans lequel, dans la formule 2,
L₁ représente l'une des formules 18 à 30 suivantes : 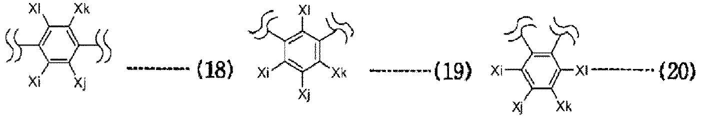 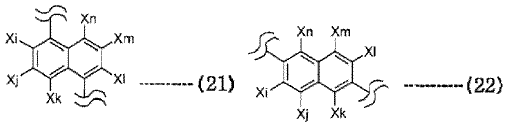 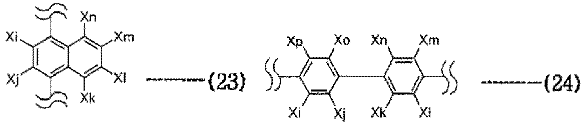 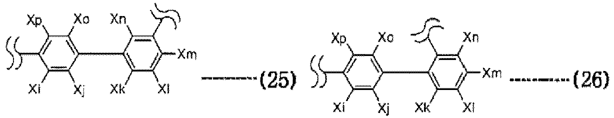 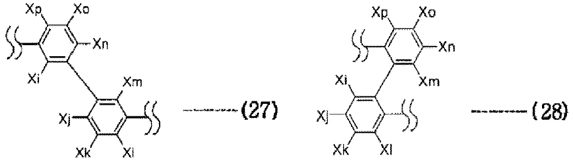 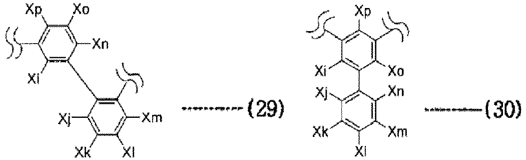 dans lequel
Xi à Xp représentent chacun indépendamment de l'hydrogène, du deutérium, un halogène, un cyano, un alkyle (C1-C30) substitué ou non substitué, un alcényle (C2-C30) substitué ou non substitué, un alcynyle (C2-C30) substitué ou non substitué, un cycloalkyle (C3-C30) substitué ou non substitué, un aryle (C6-C60) substitué ou non substitué, un hétéroaryle à 3 à 30 chaînons substitué ou non substitué, un trialkyl(C1-C30)silyle substitué ou non substitué, un triaryl(C6-C30)silyle substitué ou non substitué, un dialkyl(C1-C30)aryl(C6-C30)silyle substitué ou non substitué, ou un mono ou diaryl(C6-C30)amino substitué ou non substitué; ou des substituants adjacents peuvent être liés les uns aux autres pour former un cycle alicyclique ou aromatique (C3-C30), mono ou polycyclique, substitué ou non substitué, dont l'atome(les atomes) de carbone peut(peuvent) être remplacé(s) par au moins un hétéroatome sélectionné parmi azote, oxygène et soufre.

8. Dispositif électroluminescent organique selon la revendication 1, dans lequel dans les formules 1 et 2, les substituants de l'alkyle substitué, de l'alcényle substitué, de l'alcynyle substitué, de l'alcoxy substitué, du cycloalkyle substitué, du trialkylsilyle substitué, du dialkylarylsilyle substitué, de l'alkyldiarylsilyle substitué, du triarylsilyle substitué, du mono ou dialkylamino substitué, du mono ou diarylamino substitué, de l'alkylarylamino substitué, de l'aryl(ène) substitué, de l'hétéroaryle substitué et du cycle alicyclique ou aromatique (C3-C30) substitué, mono ou polycyclique dans R₁ à R₄, R₇ et R₈, L₁ et X₁ à X₁₆ sont chacun indépendamment au moins l'un sélectionné parmi le groupe constitué de deutérium, d'un halogène, d'un cyano, d'un carboxyle, d'un nitro, d'un hydroxyle, d'un alkyle (C1-C30), d'un haloalkyle (C1-C30), d'un alcényle (C2-C30), d'un alcynyle (C2-C30), d'un alcoxy (C1-C30), d'un alkylthio (C1-C30), d'un cycloalkyle (C3-C30), d'un cycloalcényle (C3-C30), d'un hétérocycloalkyle à 3 à 7 chaînons, d'un aryloxy (C6-C30), d'un arylthio (C6-C30), d'un hétéroaryle à 3 à 30 chaînons non substitué ou substitué par un aryle (C6-C30), un aryle (C6-C30) non substitué ou substitué par un hétéroaryle à 3 à 30 chaînons, un trialkyl(C1-C30)silyle, un triaryl(C6-C30)silyle, un dialkyl(C1-C30)aryl(C6-C30)silyle, un alkyl(C1-C30)diaryl(C6-C30)silyle, un amino, un mono ou dialkyl(C1-C30)amino, un mono ou diaryl(C6-C30)amino, un alkyl(C1-C30)aryl(C6-C30)amino, un alkyl(C1-C30)carbonyle, un alcoxy(C1-C30)carbonyle, un aryl(C6-C30)carbonyle, un diaryl(C6-C30)boronyle, un dialkyl(C1-C30)boronyle, un alkyl(C1-C30)aryl(C6-C30)boronyle, un aryl(C6-C30)alkyle(C1-C30) et un alkyl(C1-C30)aryle (C6-C30).

9. Dispositif électroluminescent organique selon la revendication 1, dans lequel le premier composé hôte représenté par la formule 1 est sélectionné parmi le groupe constitué de :

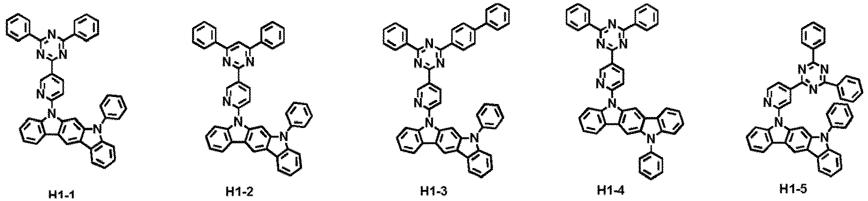

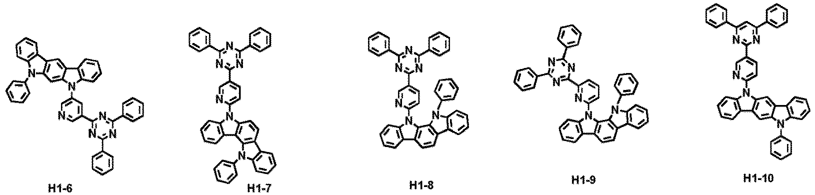

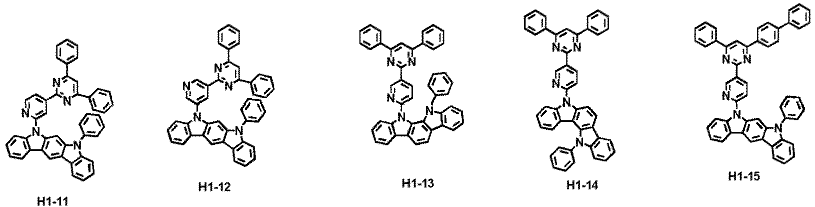

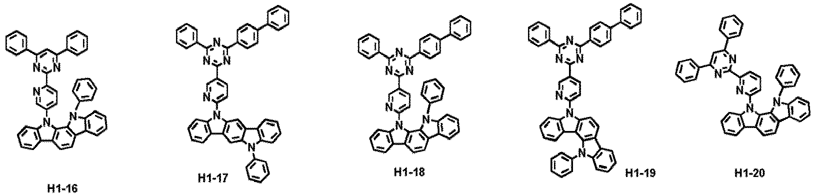

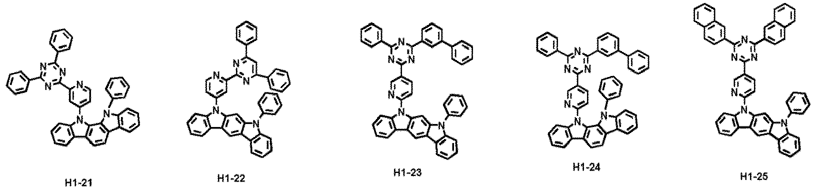

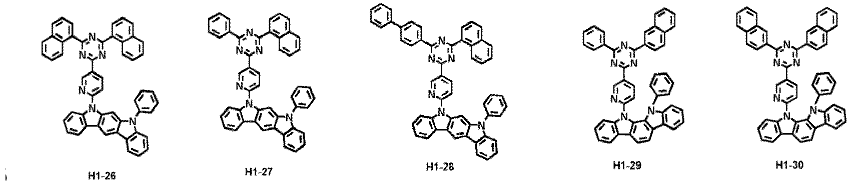

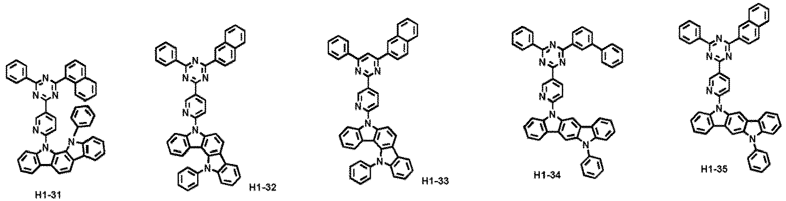

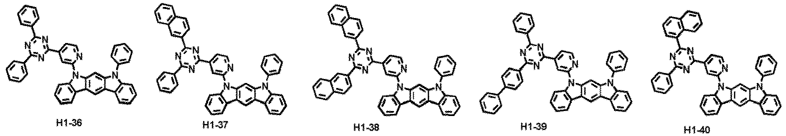

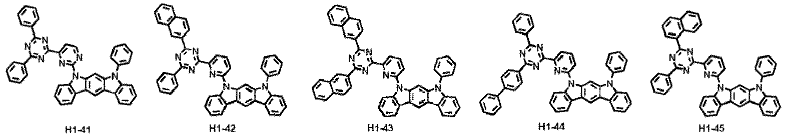

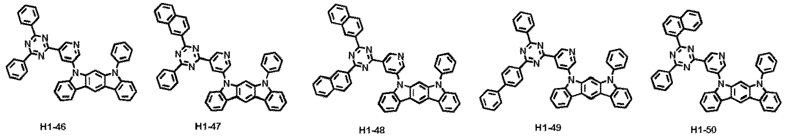

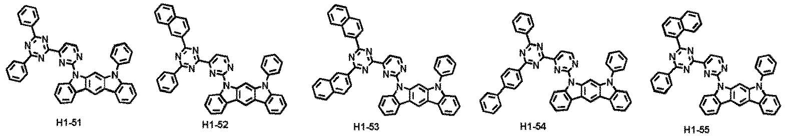

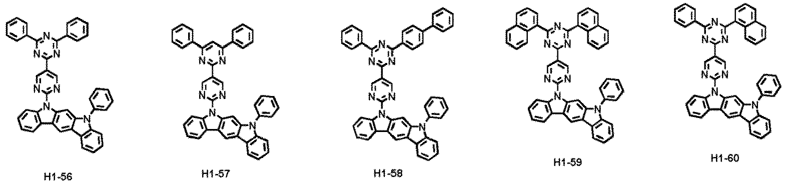

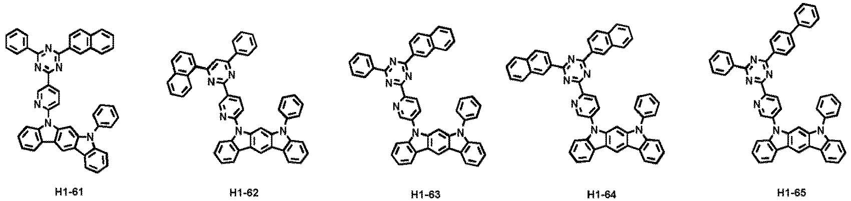

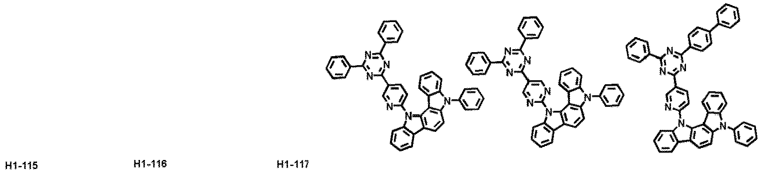

10. Dispositif électroluminescent organique selon la revendication 1, dans lequel le deuxième composé hôte représenté par la formule 2, est sélectionné parmi le groupe constitué de :
